# EUROPEAN PATENT APPLICATION

(11) **EP 4 746 612 A1**
(43) Date of publication of application: **20.05.2026**
(21) Application number: 24847541.0
(22) Date of filing: 20.02.2024
(51) Int. Cl.: H10B 12/00

(54) **MEMORY CHIP, MEMORY COMPONENT, MEMORY, AND ELECTRONIC DEVICE**

(30) Priority: 28.07.2023 CN 202310944298
(71) Applicant: Huawei Technologies Co., Ltd., Shenzhen, Guangdong 518129 (CN)
(72) Inventor: JING, Weiliang, Shenzhen, Guangdong 518129 (CN); ZHAO, Xiaoxuan, Shenzhen, Guangdong 518129 (CN); YIN, Shihui, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Maiwald GmbH
(86) International application number: PCT/CN2024/077730
(87) International publication number: WO 2025/025572

(57) **Abstract**

A memory chip, a memory component, a memory, and an electronic device are provided, to reduce metal resources occupied by a power supply trace. The memory chip includes a wafer and an active layer embedded in the wafer. The active layer includes an active device, the active device is a device in a peripheral circuit of the memory chip, and a first electrode of the active device is supplied with power by being in contact with a power supply or a ground on a backside of the wafer. Signal wiring is performed for a memory array in the memory chip by using a metal resource on a side that is of the wafer and on which an active surface is located. The peripheral circuit and the memory array are distributed at different positions of the memory chip. Therefore, a solution of setting backside power delivery in the peripheral circuit may not affect a memory device in the memory array. Therefore, on the basis of maintaining a read/write function of the memory chip, a metal resource originally serving as a power supply trace on the side that is of the wafer and on which the active surface is located can be saved, to expand input/output traces of the memory array in the memory chip, thereby increasing a bandwidth of the memory chip.

## Description

### CROSS-REFERENCE TO RELATED APPLICATIONS

This application claims priority to Chinese Patent Application No. 202310944298.0, filed with the China National Intellectual Property Administration on July 28, 2023 and entitled "MEMORY CHIP, MEMORY COMPONENT, MEMORY, AND ELECTRONIC DEVICE", which is incorporated herein by reference in its entirety.

### TECHNICAL FIELD

This application relates to the field of semiconductor technologies, and in particular, to a memory chip, a memory component, a memory, and an electronic device.

### BACKGROUND

In recent years, with in-depth development of technologies such as intelligence, digitalization, and informatization, requirements for a memory bandwidth in various fields also continuously increase. Because of advantages such as a fast access speed, being not prone to a data loss, high integration, and low power consumption, a random access memory (random access memory, RAM) in many memory products is more popular in the market, and gradually becomes a mainstream technical solution in the memory field.

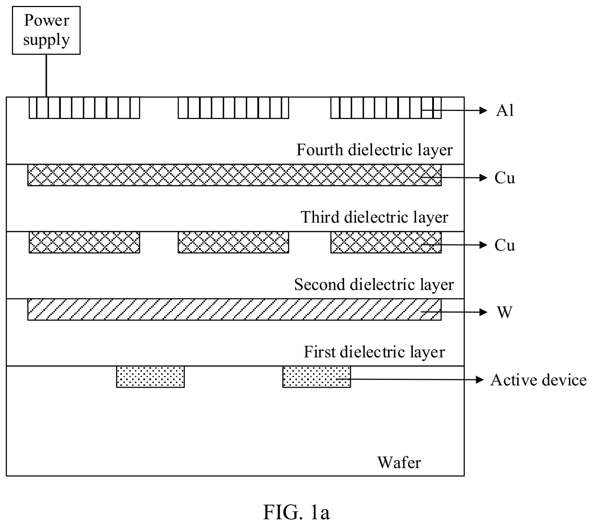

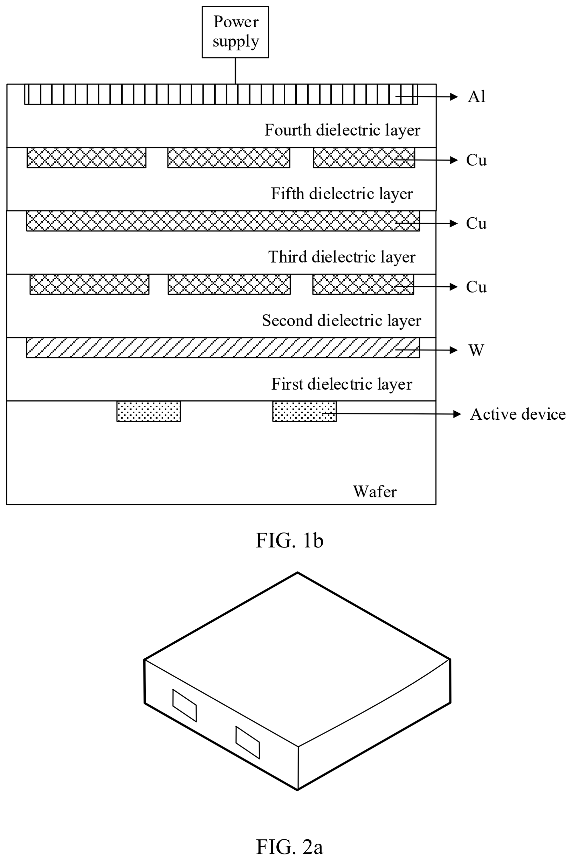

However, in a conventional memory, power supply traces account for a large proportion in each metal layer structure. For example, from bottom to top, metal layer structures of a conventional dynamic random access memory (dynamic random access memory, DRAM) are usually W/Cu/Cu/Al, as shown in FIG. 1a, or are W/Cu/Cu/Cu/Al, as shown in FIG. 1b. A surface of a first dielectric layer at which W is located is used to route a signal trace; approximately 20% of traces on a surface of a second dielectric layer at which Cu is located serve as power supply traces, and local input/output (local input/output, LIO) traces that affect a memory bandwidth account for only 5%; approximately 75% of traces on a surface of a third dielectric layer at which Cu is located serve as power supply traces, and main input/output (main input/output, MIO) traces that affect the memory bandwidth account for only 27%; if a surface of a fifth dielectric layer at which Cu is located exists, the surface is entirely used to route a power supply trace; and a surface of a fourth dielectric layer at which Al is located is mainly used to encapsulate and introduce a power supply trace and a signal trace. It can be learned that, in the conventional DRAM, a large quantity of metal layer traces serve as power supply traces, but the LIO traces and the MIO traces that are related to the memory bandwidth account for only a small proportion. A large quantity of power supply traces limit expansion of the LIO traces and the MIO traces, thereby limiting expansion of the memory bandwidth. Consequently, it is more difficult to implement a high bandwidth memory (high bandwidth memory, HBM).

In conclusion, how to reduce metal resources occupied by the power supply traces is a technical problem that urgently needs to be resolved in the field of memory technologies.

### SUMMARY

This application provides a memory chip, a memory component, a memory, and an electronic device, to reduce metal resources occupied by power supply traces.

According to a first aspect, this application provides a memory chip, including a wafer and an active layer embedded in the wafer. The active layer includes an active device, the active device is a device in a peripheral circuit of the memory chip, and a first electrode of the active device is supplied with power by being in contact with a power supply or a ground on a backside of the wafer. Signal wiring is performed for a memory array in the memory chip by using a metal resource on a side that is of the wafer and on which an active surface is located.

In the foregoing design, a power supply signal is connected from the backside of the wafer to the active device in the peripheral circuit of the memory chip. A metal resource originally serving as a power supply trace can be saved on the side that is of the wafer and on which the active surface is located, and the metal resource can be used to expand I/O traces of the memory array in the memory chip, thereby increasing a bandwidth of the memory chip. In addition, because the peripheral circuit and the memory array are distributed at different positions of the memory chip, a solution of setting backside power delivery in the peripheral circuit may not affect a memory device in the memory array. Therefore, this solution can increase the bandwidth of the memory chip on the basis of maintaining a read/write function of the memory chip.

In a possible design, the peripheral circuit may include a drive circuit, and the active device may be a device in the drive circuit, for example, a device to be supplied with power in a drive circuit stored in a hole area. In this way, a contact hole is disposed in the hole area, and the power supply signal is connected from the backside of the wafer to the drive circuit in the hole area, so that a robust power supply network can be provided for the drive circuit, thereby implementing a driving capability of the drive circuit.

In a possible design, the first electrode of the active device is in contact with the power supply or the ground on the backside of the wafer in a plurality of manners. Examples are as follows:

In a first design manner, the memory chip may further include a dielectric layer structure disposed on the active surface of the wafer and a first metal disposed in the dielectric layer structure; and the first electrode of the active device is in contact with the first metal through a first contact hole, and the first metal further penetrates through a second contact hole to the backside of the wafer, and is conducted to the power supply or the ground. In this way, a power supply signal provided by the power supply or the ground may be transferred to the active device through the second contact hole, the first metal, and the first contact hole in sequence, thereby implementing a connection between the active device and the power supply or the ground.

In a design manner 2, the wafer may include a third contact hole, one end of the third contact hole is in contact with the first electrode, and the other end of the third contact hole penetrates to the backside of the wafer and is conducted to the power supply or the ground. In this way, a power supply signal provided by the power supply or the ground may be directly transferred to the active device through the third contact hole, to implement a connection between the active device and the power supply or the ground.

Optionally, in the design manner 1, a contact area between the second contact hole and the first metal may be at least partially projected in a first area, and the first area is an area, for example, the hole area, for storing the drive circuit in the memory chip. In this way, the second contact hole is introduced into the hole area, so that the power supply network can be completely placed below the active device. In this way, a powerful power supply network can be provided for various drive circuits in the hole area, without affecting a layout of the memory array and another peripheral circuit in the memory chip, thereby avoiding affecting a storage function in the memory chip.

Optionally, in the design manner 1, the dielectric layer structure may include at least two dielectric layers, and the first metal may be disposed at any intermediate dielectric layer other than an uppermost dielectric layer. An example is as follows:

In a possible disposing manner, the dielectric layer structure may include a first dielectric layer, the first dielectric layer is located at a bottom layer of the dielectric layer structure, another dielectric layer may be further stacked above the first dielectric layer, and the first metal is disposed on a surface of the first dielectric layer. In this way, a power supply trace stacked on a surface of another dielectric layer above the first dielectric layer can be saved.

In another possible disposing manner, the dielectric layer structure includes a first dielectric layer and a second dielectric layer, the first dielectric layer is located at a bottom layer of the dielectric layer structure, the second dielectric layer is stacked above the first dielectric layer, and another dielectric layer may be further stacked above the second dielectric layer. The first metal is disposed on a surface of the second dielectric layer, a second metal is disposed on a surface of the first dielectric layer, the first metal is in contact with the second metal through the first contact hole, and the second metal is in contact with the first electrode of the active device through a fourth contact hole. In this way, a power supply trace stacked on a surface of another dielectric layer above the second dielectric layer can be saved. In addition, although the structure connects the power supply signal to the first metal on the surface of the second dielectric layer, the first metal is directly in contact with the second metal on the surface of the first dielectric layer through the contact hole. In other words, the power supply trace may not be disposed on the surface of the second dielectric layer. Therefore, according to this manner, a power supply trace on the surface of the second dielectric layer can also be saved.

It may be understood that the first metal may alternatively be disposed on a surface of another non-top dielectric layer. Examples are not listed one by one herein.

Optionally, the second contact hole in the design manner 1 and the third contact hole in the design manner 2 may have a plurality of possible structures. Examples are as follows:

Structure 1: The second contact hole or the third contact hole may include a power supply through hole and a first backside metal layer, one end of the power supply through hole is in contact with the first metal in the design manner 1 or the first electrode in the design manner 2, the other end of the power supply through hole penetrates to the first backside metal layer, and the first backside metal layer is conducted to the power supply or the ground. Through a design of the structure, the first backside metal layer may provide a wide plane. In this way, even if a plurality of active devices are disposed on the wafer, enough power supply through holes can be introduced through the wide plane, to implement a connection between the plurality of active devices and the power supply or the ground, without a need to dispose, for each active device, an external trace for a connection to the power supply/ground, thereby helping reduce occupied space of a trace.

Structure 2: The second contact hole or the third contact hole includes a power supply through hole, a first backside metal layer, a first through via, and a second backside metal layer. The second backside metal layer is disposed in a stacking direction of the first backside metal layer and is separated from the first backside metal layer by a specific distance. One end of the power supply through hole is in contact with the first metal in the design manner 1 or the first electrode in the design manner 2, the other end of the power supply through hole is in contact with the second backside metal layer, the second backside metal layer is in contact with the first backside metal layer through the first through via, and the first backside metal layer is conducted to the power supply or the ground. Through a design of this structure, even if a plane provided by the first backside metal layer is insufficient to be supplied to all active devices on the wafer, the second backside metal layer can be extended through the first through via, so that the two backside metal layers are used to support to dispose more active devices on the wafer.

It may be understood that the second contact hole or the third contact hole may further include at least three backside metal layers. Examples are not listed one by one herein.

Further, optionally, the first backside metal layer or the second backside metal layer may be spread over the backside of the wafer, and the power supply through hole may be partially projected in the first area, for example, projected only in the first area. The first area is an area, for example, a hole area, for storing the drive circuit in the memory chip. In this way, not only a powerful power supply network can be provided for various drive circuits in the hole area, but also the power supply through hole can be completely disposed below the drive circuit. Because the drive circuit, the memory array, and another peripheral circuit are located in different areas, the power supply through hole located below the drive circuit does not affect the memory array and the another peripheral circuit, thereby ensuring that functions of the memory array and the another peripheral circuit are not affected.

In a possible design, when the active device is a P-channel metal-oxide semiconductor field-effect transistor (p-channel metal-oxide semiconductor field-effect transistor, PMOSFET), the first electrode may be a source, and the first electrode is supplied with power by being in contact with the power supply. In this way, electric energy output by the power supply can be transmitted from the backside of the wafer to a source of a PMOS, so that the source of the PMOS remains at a high level.

In another possible design, when the active device is an N-channel metal-oxide semiconductor field-effect transistor (n-channel metal-oxide semiconductor field-effect transistor, NMOSFET), the first electrode may be a drain, and the first electrode is supplied with power by being in contact with the ground. In this way, a low level of the ground can be transmitted from the backside of the wafer to a drain of an NMOS, so that the drain of the NMOS remains at the low level.

According to a second aspect, this application provides a memory component, including a memory array and a peripheral circuit. The peripheral circuit includes the memory chip in any design of the first aspect, and the peripheral circuit is configured to transmit a control signal for reading/writing the memory array between the memory array and a controller.

In a possible design, the peripheral circuit may include a signal enhancement circuit and a drive circuit, and the memory chip in any design of the first aspect may be specifically located in the drive circuit. The signal enhancement circuit is connected to the memory array, and is configured to perform signal enhancement on the control signal for reading/writing the memory array. The drive circuit is connected to the signal enhancement circuit, and is configured to perform power supply enhancement on the signal enhancement circuit.

Further, in a possible design, the signal enhancement circuit may include a sub word line driver (sub word line driver, SWD) circuit and a sense amplifier (sense amplifier, SA) circuit. The SWD circuit and the SA circuit are located in a peripheral area of the memory array, and the drive circuit is located in an intersection area of the SWD circuit and the SA circuit.

Further, in a possible design, the memory array may include M×N memory cells, M word lines, and N bit lines, the M×N memory cells are located at an intersection of the M word lines and the N bit lines, and M and N are positive integers. The SWD circuit is connected to the M word lines, and is configured to perform signal enhancement on a control signal transmitted on an enabled word line. The SA circuit is connected to the N bit lines, and is configured to perform signal enhancement on a control signal transmitted on an enabled bit line.

According to a third aspect, this application provides a memory, including a controller and the memory component in any design of the second aspect. The controller is connected to the memory component, and is configured to perform a read/write operation on the memory component.

According to a fourth aspect, this application provides an electronic device, including a processor and the memory in the third aspect. The processor and the memory are connected through an I/O bus, and the processor is configured to read/write data in the memory through the I/O bus.

For beneficial effect of any design of the second aspect to the fourth aspect, refer to the beneficial effect that can be achieved in a corresponding design of the first aspect. Details are not described in this application.

### BRIEF DESCRIPTION OF DRAWINGS

FIG. 1a is a diagram of an example structure of a DRAM;
FIG. 1b is a diagram of an example structure of another DRAM;
FIG. 2a is a diagram of an example application scenario of a memory device to which this application is applicable;
FIG. 2b is a diagram of an example application scenario of a terminal device according to this application;
FIG. 3a is a diagram of an example structure of a PMOS according to this application;
FIG. 3b is a diagram of an example structure of an NMOS according to this application;
FIG. 4 is a diagram of an example structure of a memory chip according to this application;
FIG. 5 is a diagram of an example partition structure of a wafer according to this application;
FIG. 6a is a diagram of an example structure of another memory chip according to this application;
FIG. 6b is a diagram of an example structure of still another memory chip according to this application;
FIG. 6c is a diagram of an example structure of yet another memory chip according to this application;
FIG. 7 is a diagram of an example structure of a further memory chip according to this application;
FIG. 8a is a diagram of an example structure of a second contact hole according to this application;
FIG. 8b is a diagram of an example structure of another second contact hole according to this application;
FIG. 8c is a diagram of an example structure of still another second contact hole according to this application;
FIG. 9a is a diagram of an example deformed structure of a memory chip according to this application;
FIG. 9b is a diagram of an example deformed structure of another memory chip according to this application;
FIG. 10a is a diagram of an example circuit structure of an inverter according to this application;
FIG. 10b is a diagram of an example structure of a three-dimensional layout of an inverter according to this application;
FIG. 10c is a diagram of an example planar layout of an inverter according to this application;
FIG. 11 is a diagram of an example circuit comparison of extending a saved power supply trace to an I/O trace according to this application;
FIG. 12 is a diagram of an example functional framework of a memory component according to this application;
FIG. 13 is a diagram of an example functional framework of a memory according to this application; and
FIG. 14 is a diagram of an example functional framework of an electronic device according to this application.

### DESCRIPTION OF EMBODIMENTS

The following describes possible application scenarios of this application.

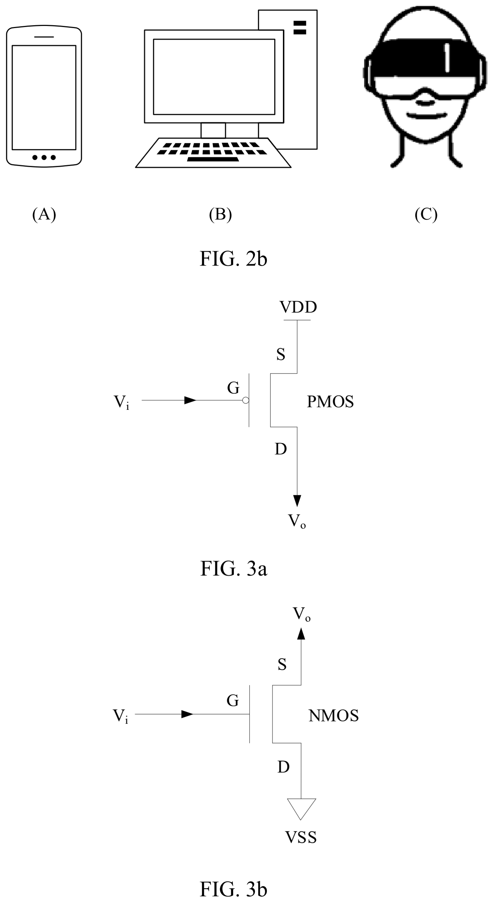

In a possible application scenario, a memory chip in this application may be integrated into a memory, for example, may be integrated into a random access memory (random access memory, RAM). The RAM may be a DRAM, a static random access memory (static RAM, SRAM), or the like. In some examples, the memory may be further integrated into a chip or a device together with the processor. The chip may be, for example, a system on chip (system on chip, SOC) chip. The device may be a device having only a read/write function, for example, a memory device shown in FIG. 2a. The memory device may be, for example, a magnetic disk, a hard disk, or a memory. Alternatively, the device may be a device that has a read/write function and further has another function, for example, a terminal device shown in FIG. 2b. For example, the terminal device may include but is not limited to a smartphone, a desktop computer, a wearable device (for example, a smart helmet or a smart watch), a vehicle-mounted device, a notebook computer, and a laptop computer (Laptop).

It should be understood that the foregoing given possible application scenario is merely an example. The memory chip provided in this application may be further applied to another possible scenario, but is not limited to the foregoing example scenario. For example, the memory chip may be further applied to a sensor, and for another example, may be further applied to an integrated circuit (integrated circuit, IC).

The foregoing describes possible application scenarios of this application, and the following explains and describes some terms in this application. It should be noted that these explanations are for ease of understanding by a person skilled in the art, and are not intended to limit the protection scope claimed by this application.

### 1. Metal-oxide semiconductor field effect transistor (metal-oxide semiconductor field effect transistor, MOSFET)

The MOSFET is a field effect transistor that may be widely used in a memory. Based on different polarities of channels of the MOSFET, the MOSFET may be classified into two types: "N-type" and "P-type", which are usually referred to as an NMOSFET and a PMOSFET, and sometimes also referred to as an NMOS and a PMOS for short. Any MOS in the NMOS and the PMOS includes three electrodes: a source (source, S), a drain (drain, D), and a gate (gate, G). A control signal is applied between the gate G and the source S, to change conduction and cutoff between the drain D and the source S. The PMOS may be usually connected to a power supply. For example, as shown in FIG. 3a, a source S of the PMOS may be connected to a power supply VDD, a gate G of the PMOS may be connected to a signal input end, and a drain D of the PMOS may be connected to a signal output end. When an input signal Vᵢ is at a low level, the source S and the drain D of the PMOS are conducted, so that a high level of the power supply VDD can be output from the drain D of the PMOS through the conducted PMOS. On the contrary, when the input signal Vᵢ is at a high level, the source S and the drain D of the PMOS are cut off, the PMOS is disconnected, and the drain D of the PMOS does not output a signal. Corresponding to the PMOS, the NMOS may be usually connected to a ground power supply. For example, as shown in FIG. 3b, a drain D of the NMOS may be connected to a ground power supply VSS, a gate G of the NMOS may be connected to a signal input end, and a source S of the NMOS may be connected to a signal output end. When an input signal Vᵢ is at a high level, the source S and the drain D of the NMOS are conducted, so that a low level of the ground power supply VSS can be output from the source S of the NMOS through the conducted NMOS. On the contrary, when the input signal is at a low level, the source S and the drain D of the NMOS are cut off, the NMOS is disconnected, and the source S of the NMOS does not output a signal.

### 2. Contact hole (contact, CT) and through via (through via, TV)

The contact hole may be considered as a structure used to connect a front-end device and a back-end metal in a back end of line (back end of line, BONL) process of manufacturing a semiconductor device. The through via may be considered as a structure used to connect different layers in manufacturing the semiconductor device. A manufacturing process of the semiconductor device is divided into a front end of line (front end of line, FONL) process and a BONL process. The FONL process is a process of preparing a wafer and an active device in the semiconductor device. The BONL process is a process of preparing a metal layer structure, for example, a process of a first dielectric layer to a fourth dielectric layer and metals on surfaces of the first dielectric layer to the fourth dielectric layer shown in FIG. 1a or FIG. 1b.

As described in the background, most traces of a metal layer structure in an existing memory are occupied by power supply traces. Consequently, expansion of I/O traces (for example, an LIO trace and an MIO trace) is limited, thereby limiting expansion of a memory bandwidth. A reason for this problem is that an initial power supply trace is introduced from an uppermost dielectric layer (for example, a fourth dielectric layer shown in FIG. 1a or FIG. 1b) in an existing memory. In order that a power supply supplies power to an active device in a wafer, a power supply trace needs to be disposed on a surface of each dielectric layer, so that the initial power supply trace introduced from the fourth dielectric layer can be connected to the active device in the wafer after passing through the power supply trace at each dielectric layer and a contact hole between metals on the surfaces of all the dielectric layers.

In view of this, this application provides a memory chip. A power supply trace in a conventional memory chip is adjusted, and a power supply signal is connected from a backside of a wafer to an active device in a peripheral circuit of the memory chip. More metal trace resources can be saved on a side on an active surface of the wafer is located, to expand I/O traces corresponding to a memory array, thereby increasing a bandwidth of the memory chip.

It should be noted that, although the interuniversity microelectronics center (interuniversity microelectronics center, IMEC) proposed a backside power delivery network (backside power delivery network, BSPDN) technology in 2019, the BSPDN technology is proposed for a logic device. The logic device usually includes 15 to 20 metal layers (a metal, at an uppermost layer, used to introduce a signal or a power supply is not considered), and most devices that need to be supplied with power are scattered on an entire surface of a wafer. Therefore, in the BSPDN technology, it is proposed that all devices to be supplied with power in the logic device are supplied with power from a backside of the wafer, to reduce a power supply voltage drop of passing through 15 to 20 metal layers for power supply, thereby reducing a power supply loss and costs. However, a memory and the logic device have a large difference in structures. For example, the memory usually includes only three or four metal layers, and a power supply voltage drop, a power supply loss, and costs of supplying power to the memory by passing through the three or four metal layers are not very high. Therefore, it is unnecessary to perform backside power delivery to reduce the power supply loss and the costs. However, if the power supply trace is moved to the backside of the wafer, a metal resource serving as a power supply trace in a conventional memory may be saved, to expand more I/O traces, thereby increasing a bandwidth. Therefore, the BSPDN technology is applied to the memory in this application. In addition, a structure of the memory is more complex than a structure of the logic device. For example, in the memory, the memory array is placed in some areas, a drive circuit is placed in some areas, a signal enhancement circuit is placed in some areas, and different devices are placed in all areas. Some of these devices need to be supplied with power, and some devices do not need to be supplied with power. Therefore, when a backside power delivery design is performed for the memory, not only a backside power delivery solution of the logic device is applied to the memory, but also a layout of a backside power delivery structure further needs to be considered. For example, which position to place the backside power delivery structure to implement backside power delivery without affecting signal wiring and functions of another device in the memory is a difficulty in the backside power delivery design of the memory.

In view of this, when designing the backside power delivery solution of the memory, the inventor considers that the memory array of the memory includes a large quantity of memory devices, and these memory devices exchange various signals through complex signal wiring on a side that is of the wafer and on which the active side is located, to implement a data read/write function of the memory. Therefore, to avoid affecting the memory devices in the memory array, in this application, a corresponding backside power delivery structure may be disposed only for a peripheral circuit of the memory, and no backside power delivery structure is disposed for the memory array. Because the peripheral circuit and the memory array are distributed at different positions of the memory, a solution of disposing the backside power delivery structure in the peripheral circuit does not affect the memory device in the memory array. Therefore, according to this solution, a metal resource originally serving as a power supply of the peripheral circuit for power supply is saved on a basis of maintaining the read/write function of the memory. The saved metal resource may be further extended into a new signal trace, for example, an I/O trace, corresponding to the memory array, to increase the bandwidth of the memory chip.

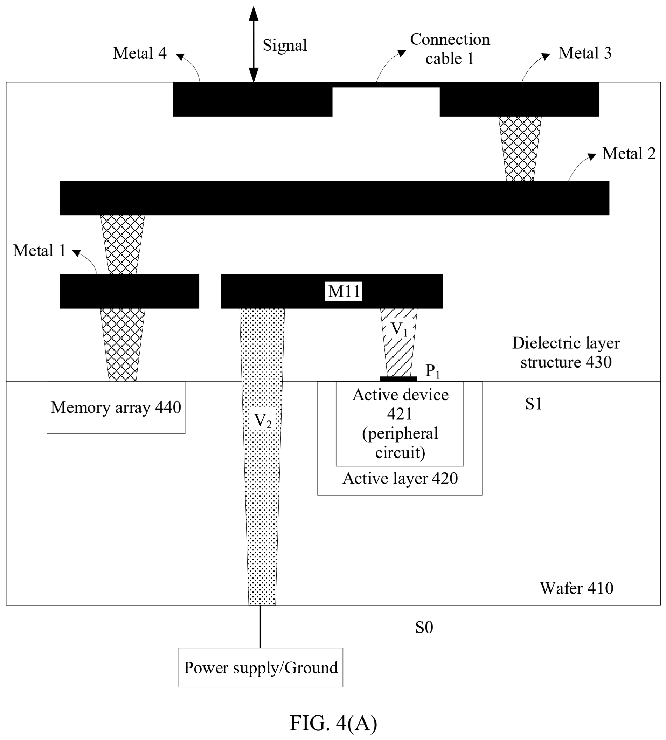

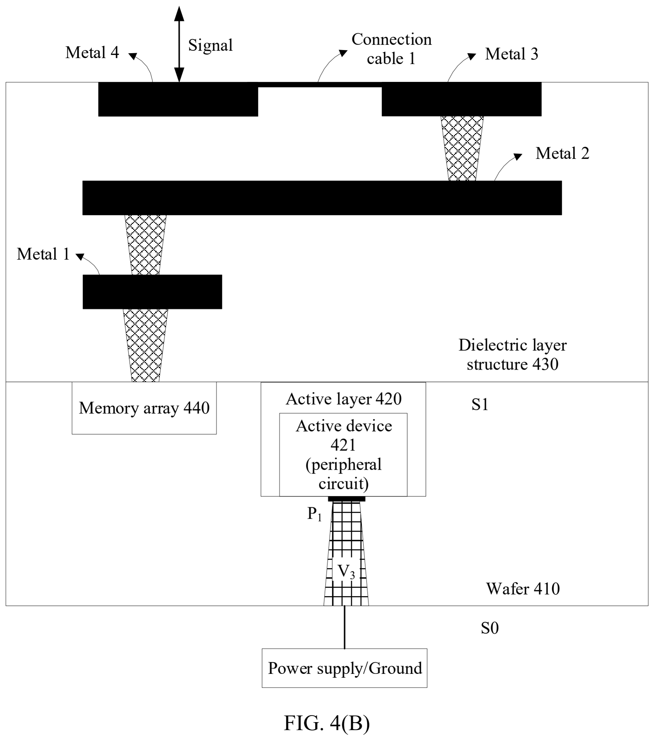

Based on the foregoing content, the following describes embodiments of this application in detail with reference to FIG. 4 to FIG. 14.

FIG. 4 is a diagram of a structure of a memory chip according to this application. The memory chip includes a wafer 410 and an active layer 420 embedded in the wafer 410. The active layer 420 includes an active device 421, the active device 421 is a device in a peripheral circuit of the memory chip, and a first electrode P₁ of the active device 421 is supplied with power by being in contact with a power supply or a ground on a backside of the wafer 410. Signal wiring is performed for a memory array 440 in the memory chip by using a metal resource on a side that is of the wafer and on which an active surface is located. That the active layer 420 is embedded in the wafer 410 may be understood as that the active layer 420 is entirely embedded in the wafer 410, and a surface of the active layer 420 is exposed on a surface of the wafer 410. The surface of the wafer 410 is referred to as the active surface of the wafer, for example, a surface S1 shown in the figure. A surface opposite to the active surface of the wafer may be referred to as the backside of the wafer 410, for example, a surface S0 shown in the figure. It may be understood that a dielectric layer structure 430 is usually further stacked on the active surface of the wafer. Therefore, the active surface of the wafer may also be understood as a surface of the wafer 410 in a stacking direction, and the backside of the wafer 410 may also be understood as a surface of the wafer 410 in a reverse stacking direction.

It should be noted that supplying power in this application may be supplying a power supply voltage, or may be supplying a ground voltage. For example, when the first electrode P₁ of the active device 421 is in contact with the power supply on the backside of the wafer 410, supplying power is providing the power supply voltage to the active device 421. When the first electrode P₁ of the active device 421 is in contact with the ground on the backside of the wafer 410, supplying power is providing the ground voltage to the active device 421.

In addition, the metal resource on the side that is of the wafer and on which the active surface is located may be understood as a metal in the dielectric layer structure 430 stacked on the active surface of the wafer and a connection cable between metals. For example, as shown in FIG. 4, the memory array 440 in the memory chip is connected to an external signal through a contact hole between the memory array 440 and a metal 1, the metal 1, a contact hole between the metal 1 and a metal 2, the metal 2, a contact hole between the metal 2 and a metal 3, the metal 3, a connection cable between the metal 3 and a metal 4, and the metal 4. Therefore, the involved metal resources may include the metal 1, the metal 2, the metal 3, the metal 4, and the connection cable between the metal 3 and the metal 4.

In this application, there are a plurality of solutions in which the first electrode P₁ is in contact with the power supply or the ground on the backside of the wafer 410. Examples are as follows:

In a possible solution, as shown in (A) in FIG. 4, the dielectric layer structure 430 includes a first metal M₁₁, the first electrode P₁ of the active device 421 is in contact with the first metal M₁₁ through a first contact hole V₁, and the first metal M₁₁ further penetrates through a second contact hole V₂ to the backside of the wafer 410, and is further conducted to the power supply or the ground. In this way, a voltage signal provided by the power supply or the ground can be transmitted to the first electrode P₁ through the second contact hole V₂, the first metal M₁₁, and the first contact hole V₁ in sequence.

In another possible solution, as shown in (B) in FIG. 4, the first electrode P₁ of the active device 421 may directly penetrate through a third contact hole V₃ to the backside of the wafer 410, and be conducted to the power supply or the ground. In this way, a voltage signal provided by the power supply or the ground may be directly transmitted to the first electrode P₁ through the third contact hole V₃.

It should be noted that, in the solution shown in (A) in FIG. 4, the first electrode P₁ may be disposed on a top surface of or inside the active device 421, and in the solution shown in (B) in FIG. 4, the first electrode P₁ may be disposed inside or at a bottom of the active device. This is not specifically limited.

It may be understood that the second contact hole V₂ shown in (A) in FIG. 4 or the third contact hole V₃ shown in (B) in FIG. 4 may be conducted to the power supply or the ground through a conductive medium, for example, may be connected to an external power supply or be in contact with a housing of the memory chip after a conductive trace passes through an encapsulation interface of the memory chip.

The following separately describes functional components and structures shown in FIG. 4, to provide an example specific implementation solution.

### 1. Wafer

The wafer is short for semiconductor crystal slice, is usually cut from a substrate material (for example, monocrystalline silicon), and is presented as a cylindrical thin slice. The wafer is usually used to prepare devices such as a memory, a computer chip, and a solar cell. For example, a storage medium and an I/O circuit are disposed on the wafer, and a memory can be formed through encapsulation. For another example, a computer chip with a computing function can be formed by integrating circuit logic into the wafer. For another example, a solar cell can be formed by depositing a P-type thin film and an N-type thin film on the wafer. Most common wafers are silicon wafers, gallium nitride wafers, silicon carbide wafers, and the like.

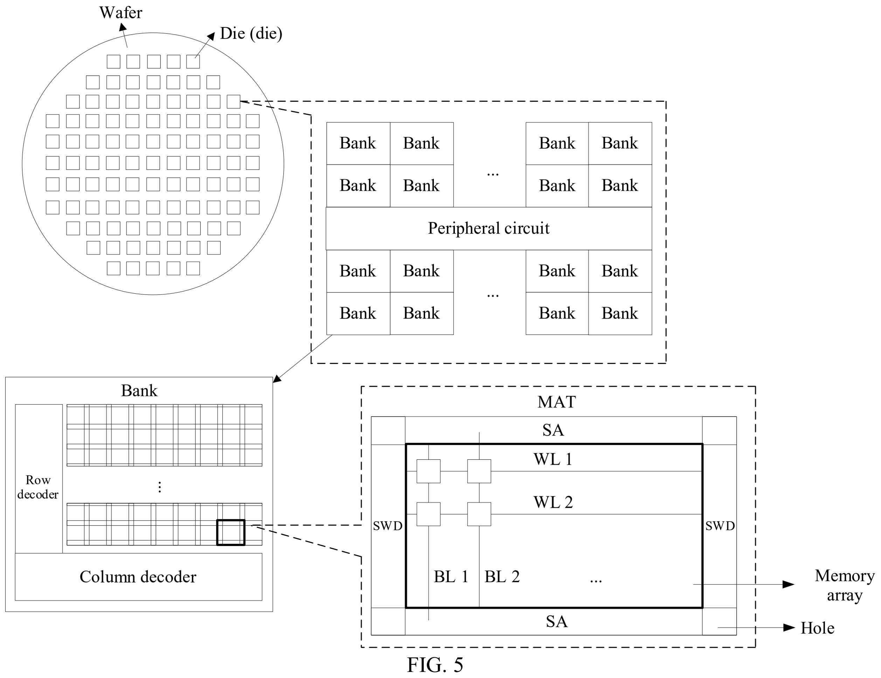

When the memory is prepared, an array of dies is formed on the surface of the wafer through photoetching and doping. For example, as shown in FIG. 5, each grid on the wafer may be considered as a die, namely, a die, and each die may include a plurality of banks and a peripheral circuit. The peripheral circuit may include, for example, a decoding circuit and a signal conversion circuit, and is configured to implement communication between a die in which the peripheral circuit is located and another die. It may be understood that, that the peripheral circuit is disposed in a direction of a central row of the plurality of banks is used as an example in the figure. However, the peripheral circuit may alternatively be disposed in any one or more positions of an upper position, a lower position, a left position, a right position, a central position, and the like in the figure, and an arrangement direction may be a row direction, a column direction, or both a row direction and a column direction. Further, each bank may include a plurality of MATs, and may further include a decoder configured to control memory cells in the plurality of MATs to perform a read/write operation, for example, a row decoder and a column decoder. One MAT may be considered as a rectangular cell array including a plurality of cells. The rectangular cell array includes a memory array and a peripheral circuit located around the memory array, for example, a sub word line driver (sub word line driver, SWD) circuit placed in a row direction (a left-right direction shown in the figure) of the memory array and a sense amplifier (sense amplifier, SA) circuit placed in a column direction (an upper-lower direction shown in the figure) of the memory array. The SWD circuit and the SA circuit may also be collectively referred to as a signal enhancement circuit. The memory array may include a plurality of word lines (word line, WL) and a plurality of bit lines (bit line, BL). A cell is distributed at an intersection of each WL and each BL. The cell is also referred to as a memory cell, and is configured to store binary data, for example, "1" or "0". The row decoder in each MAT may be connected to WLs of all memory arrays included in the MAT, and the column decoder in each MAT may be connected to BLs of all the memory arrays included in the MAT. When data stored in a memory cell in a specific column and a specific row needs to be read/written, a row decoder in a bank to which the memory cell belongs may send an enable signal to a WL corresponding to the row in which the memory cell is located, to drive all memory cells in the row in which the memory cell is located, and then send an enable signal to a BL corresponding to the column in which the memory cell is located, to drive the memory cell to be enabled. Then, a read/write operation is performed in the enabled memory cell.

It may be understood that two adjacent memory arrays in the row direction may share one SWD circuit. For example, still as shown in FIG. 5, an SWD circuit may include a left half part and a right half part. An SWD circuit corresponding to each memory array includes a right half part of an SWD circuit placed on a left side of the memory array and a left half part of an SWD circuit placed on a right side of the memory array. The SWD circuit may be connected to a WL in the memory array, and is configured to enhance an enable signal sent by a row decoder to a WL, so that the enable signal can be successfully transmitted to all memory cells in a row corresponding to the WL. Similarly, two adjacent memory arrays in the column direction may share one SA circuit. For example, still as shown in FIG. 5, an SA circuit may include an upper half part and a lower half part. An SA circuit corresponding to each memory array includes a lower half part of an SA circuit placed on an upper side of the memory array and an upper half part of an SA circuit placed on a lower side of the memory array. The SA circuit may be connected to a BL in the memory array, and is configured to enhance an enable signal sent by a column decoder to a BL, so that the enable signal can be successfully transmitted to all memory cells in a column corresponding to the BL.

In addition, in each MAT, the SWD circuit and the SA circuit may further have an intersection, for example, positions of four corners: an upper left corner, a lower left corner, an upper right corner, and a lower right corner shown in FIG. 5. These positions are usually referred to as hole areas. It should be emphasized that the hole area is not an actual hole, but an entity structure in which various drive circuits are encapsulated, and is usually used to store drive circuits of key signals used by the SWD circuit and the SA circuit, for example, a drive circuit of a PX signal used by the SWD circuit, and a drive circuit of a SAN signal and an SAP signal used by the SA circuit. The SAN signal may be considered as a signal related to an NMOS in the SA circuit, and the SAP signal may be considered as a signal related to a PMOS in the SA circuit. In short, the hole area may be considered as a driving area of the power supply. The drive circuit in the hole area is separately connected to the power supply, the SWD circuit, and the SA circuit, and is configured to perform power supply enhancement on the SWD circuit and the SA circuit based on electric energy provided by the power supply, so that the SWD circuit can be driven by enough electric energy to enhance a signal of the WL, and the SA circuit can be driven by enough electric energy to enhance a signal of the BL.

It should be noted that the memory chip in this application may be considered as one MAT shown in FIG. 5. The memory chip includes a memory array and a peripheral circuit, and the peripheral circuit may include a signal enhancement circuit and a drive circuit. The signal enhancement circuit may include, for example, the SWD circuit and SA circuit, and the drive circuit may include, for example, the circuit in the hole area.

### 2. Active device

For example, the active device 421 may be a device that needs to be supplied with power in the drive circuit of the memory chip, for example, a device that needs to be supplied with power in the drive circuit stored in the hole area shown in FIG. 5. In this way, a contact hole is disposed in the hole area of the wafer shown in FIG. 5, and a power supply signal is connected from the backside of the wafer to the drive circuit in the hole area, so that a robust power supply network is provided through backside power delivery to drive the SWD circuit and the SA circuit, without affecting a memory device in the memory array, the SWD circuit, and the SA circuit. In this way, a power supply trace that is originally on the side of the active side of the wafer and that shares a metal trace resource with a signal is saved while a storage capability is maintained, to increase I/O traces and increase a memory bandwidth.

It may be understood that, in the hole area, the drive circuit usually includes basic units such as an inverter, a counter, a latch, and a flip-flop, and each basic unit includes one or more PMOSs and/or one or more NMOSs. Therefore, the PMOS and the NMOS may be considered as minimum constituent units of the drive circuit in the hole area. Based on this, the active device 421 may be considered as a PMOS or an NMOS in the drive circuit stored in the hole area shown in FIG. 5.

For example, with reference to FIG. 3a and FIG. 4, when the active device 421 is a PMOS, the first electrode P₁ may be a source S, and the first metal M₁₁ may be conducted to the power supply VDD on the backside of the wafer 410. In this way, electric energy output by the power supply VDD can be transmitted from the backside of the wafer 410 to the source S of the PMOS, so that the source S of the PMOS remains at a high level.

For example, with reference to FIG. 3b and FIG. 4, when the active device 421 is an NMOS, the first electrode P₁ may be a drain D, and the first metal M₁₁ may be conducted to the ground power supply VSS on the backside of the wafer 410. In this way, a low level of the ground power supply VSS can be transmitted from the backside of the wafer 410 to the drain D of the NMOS, so that the drain D of the NMOS remains at the low level.

### 3. Dielectric layer structure

It may be understood that the dielectric layer structure 430 may include at least one dielectric layer. The dielectric layer may also be referred to as a dielectric layer, an inter-dielectric layer, or an inter-dielectric layer (inter-dielectric layer, ILD), is an electrical insulation layer disposed between different layers of the memory chip, and plays a role of a separator. Optionally, the dielectric layer may include oxide, for example, silicon dioxide (SiO₂).

For example, a plurality of blind holes of different sizes may be dug on a surface of any dielectric layer. These blind holes are used to be filled with a metal. Metal materials filled at one dielectric layer may be consistent or may be inconsistent. In some scenarios, the metal at the dielectric layer may also be referred to as a metal plug, and is an electrode having a conductive capability. An implementation material of the metal may include copper, cobalt, tungsten, rubidium, or another metal material having strong conductive performance.

It may be understood that, when the first electrode P₁ is connected to the power supply or the ground on the backside of the wafer 410 in the manner shown in (B) in FIG. 4, no power supply trace needs to be disposed in the entire dielectric layer structure 430. However, when the first electrode P₁ is connected to the power supply or the ground on the backside of the wafer 410 in the manner shown in (A) in FIG. 4, a power supply trace that needs to be disposed in the dielectric layer structure 430 is related to a position of the first metal M₁₁. For example, the memory chip belongs to the DRAM shown in FIG. 1a. It is assumed that the dielectric layer structure 430 includes a first dielectric layer, a second dielectric layer, a third dielectric layer, and a fourth dielectric layer that are stacked in sequence. In consideration that a surface of the first dielectric layer is entirely used to route a signal trace, the fourth dielectric layer serves as an encapsulation layer, basically no power supply trace is routed at the two dielectric layers, and most power supply traces are basically distributed at the second dielectric layer and the third dielectric layer at a current stage, the power supply signal may be connected from the backside of the wafer 410 to a metal on a surface of either the first dielectric layer or the second dielectric layer, to save a power supply trace at the second dielectric layer and/or the third dielectric layer.

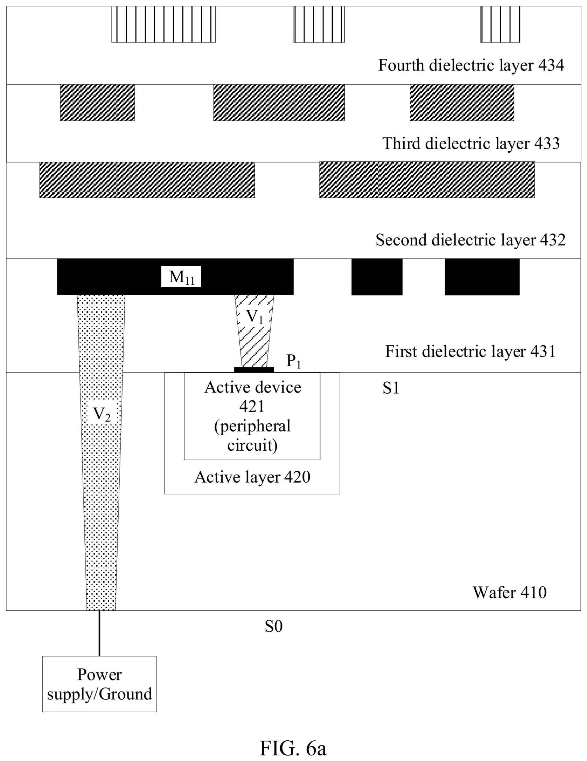

A manner in which the first electrode P₁ is connected to the power supply or the ground is described in detail with reference to FIG. 6a to FIG. 6c below. It should be noted that, for ease of describing the solution, the memory array and the corresponding signal trace in the memory chip are omitted in FIG. 6a to FIG. 6c.

In a possible implementation, as shown in FIG. 6a, the first metal M₁₁ may be disposed on a surface of a first dielectric layer 431. In this way, the voltage signal of the power supply/ground may be transmitted to the first electrode P₁ of the active device 421 through the second contact hole V₂, the first metal M₁₁ at the first dielectric layer 431, and the first contact hole V₁. According to this manner, a power supply trace on a surface of another dielectric layer above the first dielectric layer 431, for example, a power supply trace on a surface of the second dielectric layer 432 and a surface of the third dielectric layer 433, may be saved.

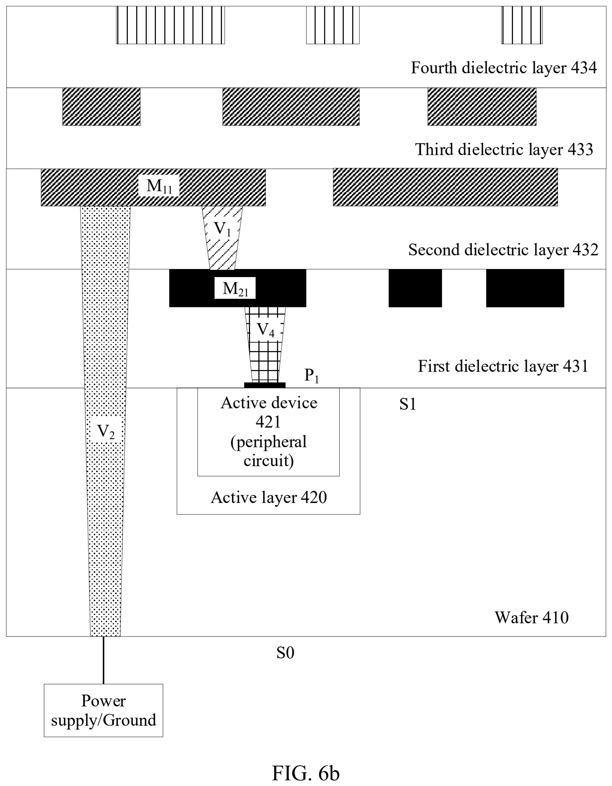

In another possible implementation, as shown in FIG. 6b, the first metal M₁₁ may be disposed on a surface of a second dielectric layer 432, a second metal M₂₁ may be disposed on a surface of a first dielectric layer 431, the first metal M₁₁ is in contact with the second metal M₂₁ through the first contact hole V₁, and the second metal M₂₁ is in contact with the first electrode P₁ of the active device 421 through a fourth contact hole V₄. In this case, the voltage signal of the power supply/ground may be transmitted to the first electrode P₁ of the active device 421 through the second contact hole V₂, the first metal M₁₁ at the second dielectric layer 432, the first contact hole V₁, the second metal M₂₁ at the first dielectric layer 431, and the fourth contact hole V₄. Although the power supply signal is connected to the metal on the surface of the second dielectric layer 432 in this manner, the metal on the surface is directly in contact with the metal on the surface of the first dielectric layer 431 through the contact hole. Therefore, according to this manner, a power supply trace on a surface of another dielectric layer above the first dielectric layer 431 may also be saved.

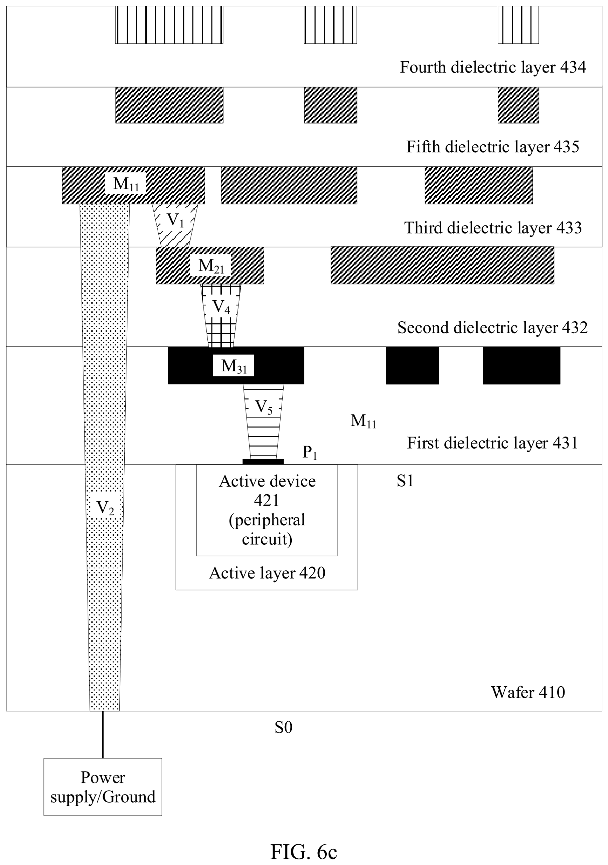

Similarly, if the memory chip belongs to the DRAM shown in FIG. 1b, the dielectric layer structure 430 further includes a fifth dielectric layer stacked between the third dielectric layer and the fourth dielectric layer. In this case, power supply traces are not only distributed at the second dielectric layer and the third dielectric layer, but also a surface of the fifth dielectric layer is entirely used for power supply traces. Therefore, in still another possible implementation, a power supply signal may be further connected from the backside of the wafer 410 to a metal on a surface of a third dielectric layer, to save a power supply trace at a fifth dielectric layer. For example, as shown in FIG. 6c, the first metal M₁₁ may be disposed on the surface of the third dielectric layer 433, a second metal M₂₁ may be disposed on a surface of a second dielectric layer 432, a third metal M₃₁ may be disposed on a surface of a first dielectric layer 431, the first metal M₁₁ is in contact with the second metal M₂₁ through the first contact hole V₁, the second metal M₂₁ is in contact with the third metal M₃₁ through a fourth contact hole V₄, and the third metal M₃₁ is in contact with the first electrode P₁ of the active device 421 through a fifth contact hole V₅. In this case, the voltage signal of the power supply/ground may be transmitted to the first electrode P₁ of the active device 421 through the second contact hole V₂, the first metal M₁₁ at the third dielectric layer 433, the first contact hole V₁, the second metal M₂₁ at the second dielectric layer 432, the fourth contact hole V₄, the third metal M₃₁ at the first dielectric layer 431, and the fifth contact hole V₃. According to this manner, a power supply trace on a surface of another dielectric layer above the third dielectric layer 433, for example, a power supply trace on the surface of the fifth dielectric layer 435, may be saved.

It may be understood that, in some other scenarios, a power supply trace may also be disposed on a surface of the fourth dielectric layer 434. Therefore, to save the power supply trace on the surface of the fourth dielectric layer 434, the first metal M₁₁ may be further disposed on the surface of the third dielectric layer 433 shown in FIG. 6a or FIG. 6b, or may be further disposed on the surface of the fifth dielectric layer 435 shown in FIG. 6c. Details are not described one by one herein.

It may be understood that, in the foregoing memory chip, when the memory chip belongs to the DRAM, the metal disposed at the first dielectric layer 431 may be tungsten W, the metal disposed at the second dielectric layer 432, the third dielectric layer 433, and the fifth dielectric layer 435 may be copper Cu, and the metal disposed at the fourth dielectric layer 434 may be aluminum Al.

It may be understood that, more power supply traces may be saved when the dielectric layer at which the first metal M₁₁ is located is closer to the wafer 410. For example, the foregoing disposing manner shown in FIG. 6a is used as an example. As described in the background, power supply traces on the surface of the second dielectric layer 432 occupy 20% of traces, and LIO traces occupy 5% of traces. After the power supply trace is changed to the backside of the wafer 410, the 20% of traces saved on the surface of the second dielectric layer 432 may be all used to expand the LIO traces, so that a quantity of LIO traces can be increased by four times. Similarly, power supply traces on the surface of the third dielectric layer 433 occupy 75% of traces, and MIO traces occupy 27% of traces. After the power supply trace is changed to the backside of the wafer 410, the 75% of traces saved on the surface of the third dielectric layer 433 may be all used to expand the MIO traces, so that a quantity of MIO traces can be increased by approximately 2.77 times. Because the quantity of MIO traces and the quantity of LIO traces in the memory chip need to be consistent, to adapt to the 2.77 times of the MIO traces obtained through expansion on the surface of the third dielectric layer 433, 2.77 times of the LIO traces also need to be obtained through expansion on the surface of the second dielectric layer 432. In other words, a bandwidth of the memory chip may be expanded by 2.77 times. In addition, after the bandwidth of the memory chip is expanded, some saved traces may still remain on the surface of the second dielectric layer 432. These traces may serve as other types of traces, or may be idle.

For ease of describing the solution, the following continues to describe a possible structure of the dielectric layer by using the memory chip shown in FIG. 6a as an example. It should be noted that, for ease of illustration, another dielectric layer stacked above the first dielectric layer 431 is omitted in the following figure.

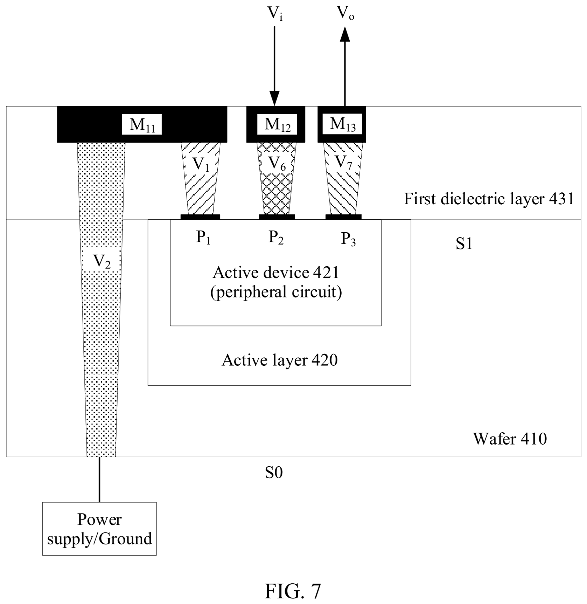

For example, as shown in FIG. 7, a metal M₁₂ may be further disposed at the first dielectric layer 431, a second electrode P₂ of the active device 421 is in contact with the metal M₁₂ through a contact hole V₆, and the metal M₁₂ is configured to receive an input signal Vᵢ. Optionally, the input signal Vᵢ may be input by the peripheral circuit of the memory chip. For example, the input signal Vᵢ may pass through the encapsulation interface of the memory chip through a signal trace and then reach a surface of an uppermost dielectric layer; is connected to the metal M₁₂ at the lowermost first dielectric layer 431 through a signal trace on a surface of each dielectric layer and a contact hole between dielectric layers; and is transmitted to the active device 421 through the metal M₁₂ and the contact hole V₆.

It may be understood that, with reference to FIG. 3a, FIG. 3b, and FIG. 7, when the active device 421 is a PMOS or an NMOS, the second electrode P₂ may be a gate G. In this way, the PMOS or the NMOS may receive the input signal Vᵢ on the gate G through the contact hole V₆, to provide support for controlling conduction or cutoff between a source S and a drain D.

In a possible implementation, still as shown in FIG. 7, a metal M₁₃ may be further disposed at the first dielectric layer 431, a third electrode P₃ of the active device 421 is in contact with the metal M₁₃ through a contact hole V₇, and the metal M₁₃ is configured to send an output signal Vₒ. Optionally, the output signal Vₒ may be output to the peripheral circuit of the memory chip. For example, the output signal Vₒ may be transmitted to the metal M₁₃ at the lowermost first dielectric layer 431 through the contact hole V₇; is connected to a surface of an uppermost dielectric layer through a signal trace on a surface of each dielectric layer and a contact hole between dielectric layers; and passes through the encapsulation interface of the memory chip and is output to the peripheral circuit.

It may be understood that, with reference to FIG. 3a and FIG. 7, when the active device 421 is a PMOS, the third electrode P₃ may be a drain D. In this way, when the PMOS is conducted, a high level of a source S of the PMOS may be transmitted to the drain D through the conducted PMOS, and then output to the peripheral circuit.

It may be understood that, with reference to FIG. 3b and FIG. 7, when the active device 421 is an NMOS, the third electrode P₃ may be a source S. In this way, when the NMOS is conducted, a low level of a drain D of the NMOS may be transmitted to the source S through the conducted NMOS, and then output to the peripheral circuit.

### 4. Second contact hole or third contact hole

In a possible implementation, a contact area between the second contact hole V₂ and the first metal M₁₁ shown in (A) in FIG. 4 or a contact area between the third contact hole V₃ and the first electrode P₁ shown in (B) in FIG. 4 may be at least partially projected in the first area, for example, may be entirely projected in the first area. The first area is an area, for example, the hole area shown in FIG. 5, for storing the drive circuit in the memory chip. In other words, the contact hole may be introduced into the hole area, and the power supply signal is introduced from the backside of the wafer to the active device through the contact hole, so that the power supply network is completely placed below the active device, and there may be completely no intersection between the power supply network and each of the memory array and another peripheral circuit. In this way, a powerful power supply network can be provided for various drive circuits in the hole area, without affecting a layout of the memory array and another peripheral circuit in the memory chip, thereby avoiding affecting a storage function in the memory chip.

In this application, the second contact hole V₂ or the third contact hole V₃ needs to penetrate through the backside of the wafer 410. The second contact hole V₂ or the third contact hole V₃ may be a through hole of a regular shape, or may be an irregularly-shaped hole formed when different through holes and metal layers are in contact with each other. For ease of describing the solution, the following lists several possible structures of the second contact hole V₂ by using the second contact hole V₂ shown in FIG. 7 as an example. It may be understood that the possible structure of the second contact hole V₂ is also applicable to the third contact hole V₃. A difference lies in that one end of the second contact hole V₂ is in contact with the first metal M₁₁, but one end of the third contact hole V₃ is in contact with the first electrode P₁.

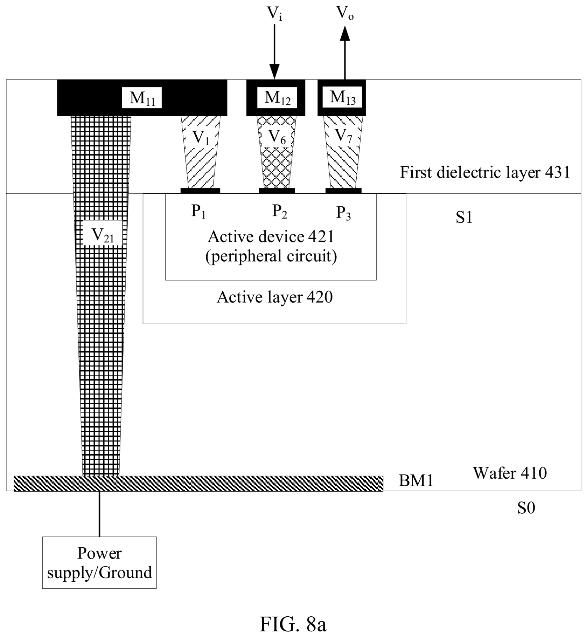

In a possible structure, as shown in FIG. 8a, the second contact hole V₂ may include a power supply through hole V₂₁ and a first backside metal layer BM1. One end of the power supply through hole V₂₁ is in contact with the first metal M₁₁, and the other end penetrates to the first backside metal layer BM1. The first backside metal layer BM1 is disposed on the backside of the wafer 410, and is conducted to the power supply or the ground. For example, the first backside metal layer BM1 may be conducted to the power supply or the ground through a conductive medium. The conductive medium may be a single medium or a hybrid medium having a conductive capability, for example, a metal, an alloy (for example, a copper alloy or an aluminum alloy), a composite metal, a conductive plastic, a conductive rubber, a conductive fiber fabric, a conductive coating, a conductive adhesive, a transparent conductive thin film, and a composite material thereof. Through a design of the structure, the first metal M₁₁ may be connected to the power supply or the ground through the power supply through hole V₂₁ and the first backside metal layer BM1, and the first backside metal layer BM1 may provide a wide plane. In this way, even if a plurality of active devices 421 are disposed on the wafer 410, enough power supply through holes V₂₁ can be introduced through the wide plane, to implement a connection between the plurality of active devices and the power supply or the ground, without a need to dispose, for each active device, an external trace for a connection to the power supply/ground, thereby helping reduce occupied space of an external trace.

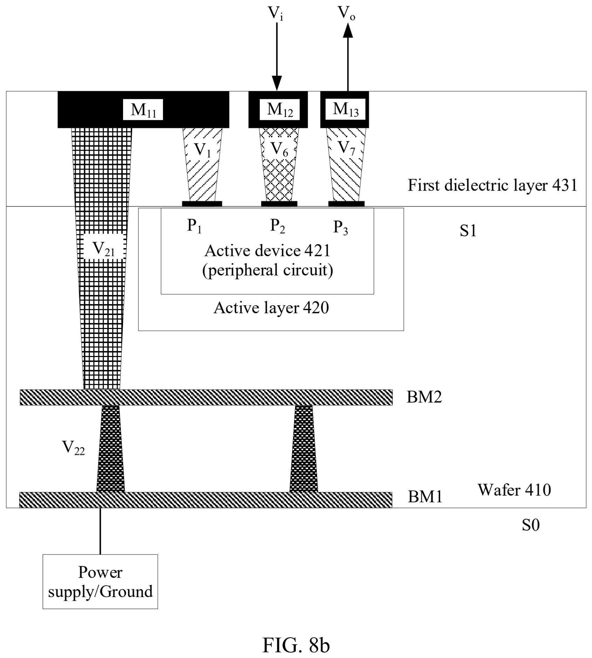

In another possible structure, as shown in FIG. 8b, the second contact hole V₂ may include a power supply through hole V₂₁, a second backside metal layer BM2, a first through via V₂₂, and a first backside metal layer BM1. The first backside metal layer BM1 is disposed on the backside of the wafer 410 and is conducted to the power supply or the ground, and the second backside metal layer BM2 is disposed in a stacking direction of the first backside metal layer BM1 and is separated from the first backside metal layer BM1 by a specific distance. One end of the power supply through hole V₂₁ is in contact with the first metal M₁₁, and the other end penetrates to the second backside metal layer BM2. One end of the first through via V₂₂ is in contact with the second backside metal layer BM2, and the other end is in contact with the first backside metal layer BM1. In this way, the first metal M₁₁ may be connected to the power supply or the ground through the power supply through hole V₂₁, the second backside metal layer BM2, the first through via V₂₂, and the first backside metal layer BM1 in sequence. In addition, even if a plane provided by the first backside metal layer BM1 is insufficient to be supplied to all active devices 421 on the wafer 410, the second backside metal layer BM2 can be extended through the first through via V₂₂, so that the two backside metal layers are used to support to dispose more active devices 421 on the wafer 410.

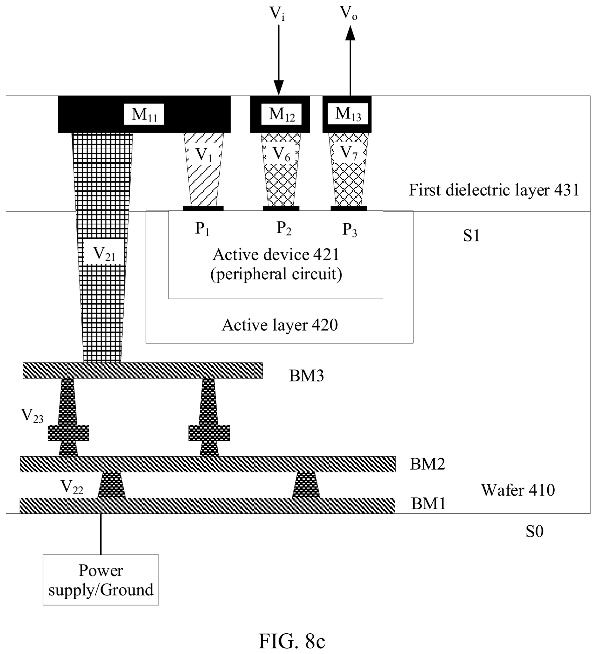

In still another possible structure, as shown in FIG. 8c, the second contact hole V₂ may include a power supply through hole V₂₁, a third backside metal layer BM3, a second through via V₂₃, a second backside metal layer BM2, a first through via V₂₂, and a first backside metal layer BM1. The first backside metal layer BM1 is disposed on the backside of the wafer 410 and is conducted to the power supply or the ground. The second backside metal layer BM2 is disposed in a stacking direction of the first backside metal layer BM1 and is separated from the first backside metal layer BM1 by a specific distance. The third backside metal layer BM3 is disposed in a stacking direction of the second backside metal layer BM2 and is separated from the second backside metal layer BM2 by a specific distance. One end of the power supply through hole V₂₁ is in contact with the first metal M₁₁, and the other end penetrates through the third backside metal layer BM3. One end of the second through via V₂₃ is in contact with the third backside metal layer BM3, and the other end is in contact with the second backside metal layer BM2. One end of the first through via V₂₂ is in contact with the second backside metal layer BM2, and the other end is in contact with the first backside metal layer BM1. In this way, the first metal M₁₁ may be connected to the power supply or the ground through the power supply through hole V₂₁, the third backside metal layer BM3, the second through via V₂₃, the second backside metal layer BM2, the first through via V₂₂, and the first backside metal layer BM1 in sequence. Through a design of the structure, even if a plane provided by the first backside metal layer BM1 and the second backside metal layer BM2 is insufficient to be supplied to all active devices 421 on the wafer 410, the third backside metal layer BM3 can be extended through the second through via V₂₃, so that the three backside metal layers are used to support to dispose more active devices 421 on the wafer 410.

It should be noted that, in the foregoing structures, all backside metal layers and all through vias may be distributed on the entire backside of the wafer 410, but the power supply through hole V₂₁ is distributed only in the hole area shown in FIG. 5. In this way, a powerful power supply network can be provided for various drive circuits in the hole area, without affecting a position of another device in the memory array, thereby avoiding affecting the memory device in the memory array.

In addition, the foregoing merely describes examples of three possible structures of the second contact hole V₂. In an actual operation, there may be another structure. For example, more than three backside metal layers may be included. For example, four or five backside metal layers may be included. More disposed backside metal layers can provide a wider plane to support more active devices 421, but a manufacturing process of the memory chip becomes more complex.

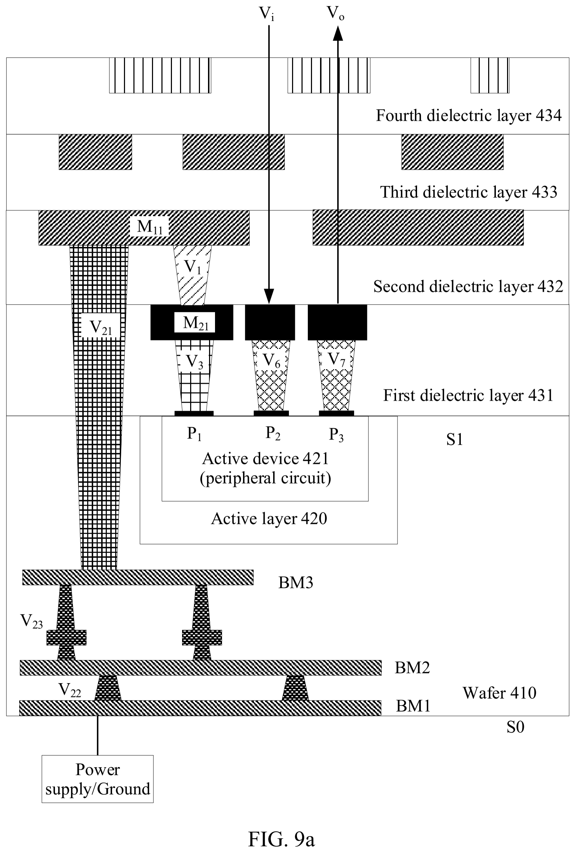

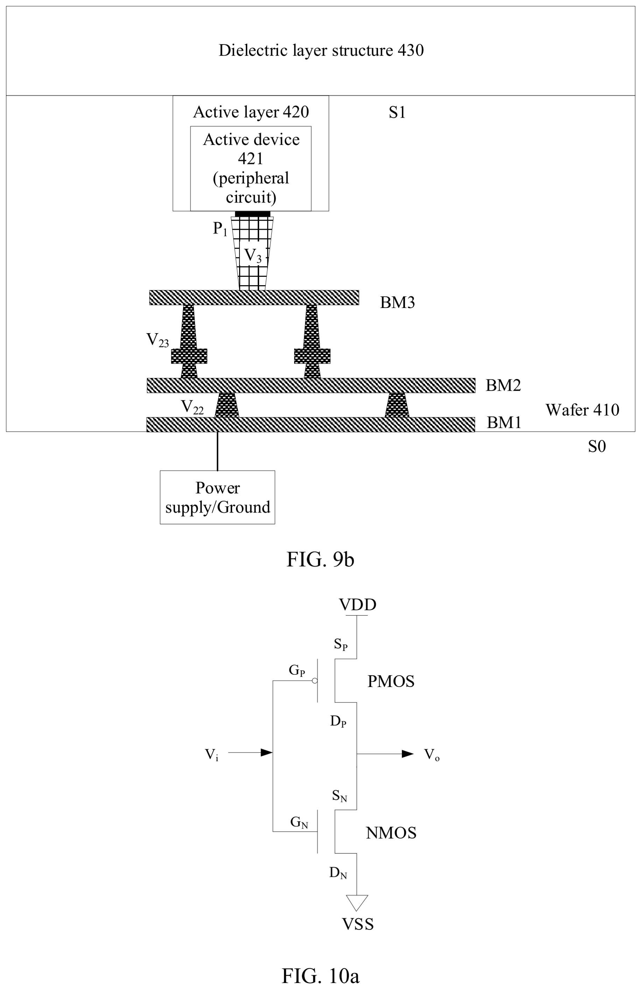

In addition, the implementation solutions described in this application may be further combined with each other. For example, FIG. 7 to FIG. 8c are described by using the structure of the memory chip shown in FIG. 6a as an example. However, the solution thereof may also be applicable to the structure of the memory chip shown in FIG. 6b or FIG. 6c. For example, the structure of the memory chip shown in FIG. 9a may be further obtained by combining the solution shown in FIG. 8c with the structure of the memory chip shown in FIG. 6b. For another example, FIG. 6a to FIG. 8c are described by using the structure of the memory chip shown in (A) in FIG. 4 as an example. However, the solution thereof may also be applicable to the structure of the memory chip shown in (B) in FIG. 4. For example, the structure of the memory chip shown in FIG. 9b may be further obtained by combining the solution shown in FIG. 8c with the structure of the memory chip shown in (B) in FIG. 4. It should be understood that many possible structures of the memory chip may be obtained by combining the implementation solutions. Details are not listed one by one in this application.

The foregoing content describes a structure in which backside power delivery is performed on a single active device in the memory chip. The following describes a backside power delivery solution for a basic unit including a plurality of active devices in the memory chip. For example, an example in which the basic unit is an inverter in the drive circuit is used below.

FIG. 10a is a diagram of an example circuit of an inverter according to this application. The inverter includes one PMOS and one NMOS. A gate G_{P} of the PMOS is connected to a gate G_{N} of the NMOS, and is configured to receive an input signal Vᵢ. A drain D_{P} of the PMOS is connected to a source S_{N} of the NMOS, and is configured to send an output signal Vₒ. A source S_{P} of the PMOS is connected to a power supply VDD, and a drain D_{N} of the NMOS is connected to a ground terminal VSS. When the input signal Vᵢ is at a high level, the NMOS is conducted, and the PMOS is cut off. Therefore, a low level of the ground terminal VSS may be output through the conducted NMOS, so that the inverter outputs a low level opposite to the input signal Vᵢ. When the input signal Vᵢ is at a low level, the PMOS is conducted, and the NMOS is cut off. Therefore, a high level of the power supply VDD may be output through the conducted PMOS, so that the inverter outputs a high level opposite to the input signal Vᵢ.

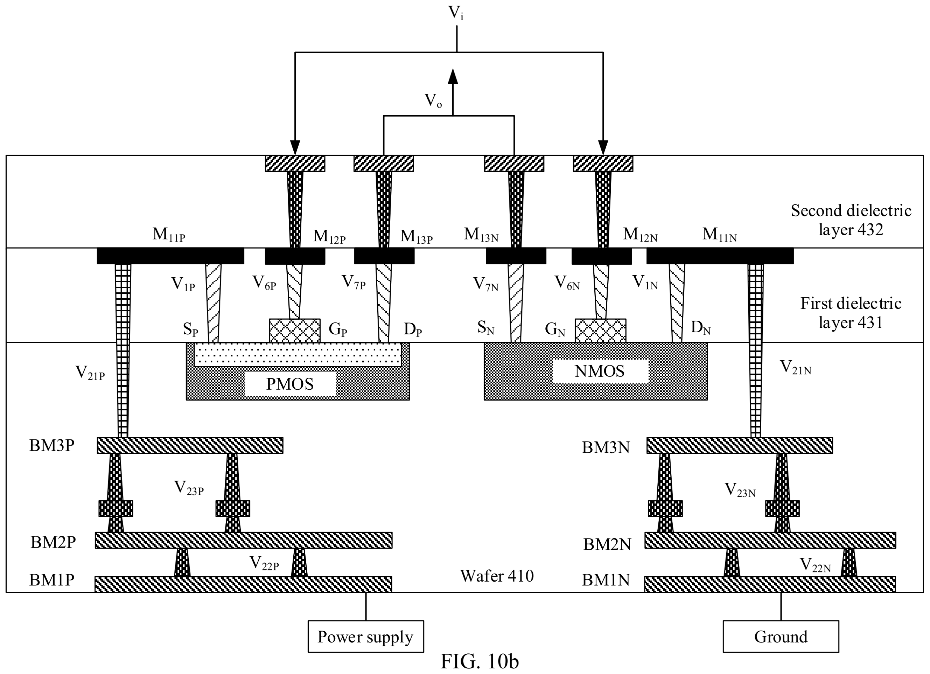

For example, the structure of the memory chip shown in FIG. 8c is used as an example. Based on FIG. 10a, FIG. 10b is a diagram of an example structure of a three-dimensional layout of an inverter according to this application. In the three-dimensional layout, a first dielectric layer 431 is stacked on a wafer 410. An active layer is embedded in the wafer 410, and a PMOS and an NMOS are disposed at the active layer. A plurality of backside metal layers are further disposed in the wafer 410, and include a backside metal layer BM1P, a backside metal layer BM2P, and a backside metal layer BM3P that are disposed for the PMOS, and a backside metal layer BM1N, a backside metal layer BM2N, and a backside metal layer BM3N that are disposed for the NMOS. The backside metal layer BM1P is connected to a power supply, and the backside metal layer BM1N is connected to a ground. The backside metal layer BM1P and the backside metal layer BM2P are connected through a through via V_{22P}, and the backside metal layer BM2P and the backside metal layer BM3P are connected through a through via V_{23P}. The backside metal layer BM1N and the backside metal layer BM2N are connected through a through via V_{22N}, and the backside metal layer BM2N and the backside metal layer BM3N are connected through a through via V_{23N}. Blind holes of different sizes are dug on a surface of the first dielectric layer 431, and the blind holes are filled with metals. The metals include a metal M_{11P}, a metal M_{12P}, and a metal M_{13P} that are disposed for the PMOS, and a metal M_{11N}, a metal M_{12N}, and a metal M_{13N} that are disposed for the NMOS. The metal M_{11P} is in contact with the backside metal layer BM3P through a power supply through hole V_{21P} and is in contact with a source S_{P} of the PMOS through a contact hole V_{1P}, the metal M_{12P} is in contact with a gate G_{P} of the PMOS through a contact hole V_{6P}, and the metal M_{13P} is in contact with a drain D_{P} of the PMOS through a contact hole V_{7P}. The metal M_{11N} is in contact with the backside metal layer BM3N through a power supply through hole V_{21N} and is in contact with a drain D_{N} of the NMOS through a contact hole V_{1N}, the metal M_{12N} is in contact with a gate G_{N} of the NMOS through a contact hole V_{6N}, and the metal M_{13N} is in contact with a source S_{N} of the NMOS through a contact hole V_{7N}. The metal M_{13P} and the metal M_{13N} each are in contact with and then connected to a metal at a second dielectric layer 432 through a contact hole at the second dielectric layer 432, and are conducted to a signal output end, so that the drain D_{P} of the PMOS and the source S_{N} of the NMOS are conducted to the signal output end; and the metal M_{12P} and the metal M_{12N} each are in contact with and then connected to a metal at the second dielectric layer 432 through a contact hole at the second dielectric layer 432, and are conducted to a signal input end, so that the gate G_{P} of the PMOS and the gate G_{N} of the NMOS are conducted to the signal input end. It should be understood that another dielectric layer stacked above the second dielectric layer 432 and a manner of connecting a metal at the another dielectric layer and the gate G_{P} of the PMOS, the gate G_{N} of the NMOS, the drain D_{P} of the PMOS, and the source S_{N} of the NMOS are omitted in the figure.

Based on the structure of the three-dimensional layout, the backside metal layers BM1P to BM3P serve as power supply metals; the power supply is connected to the metal M_{11P} at the first dielectric layer 431 through the through via V_{22P}, the through via V_{23P}, and the power supply through hole V_{21P}; and the metal M_{11P} at the first dielectric layer 431 is connected to the source S_{P} of the PMOS through the contact hole V_{1P}, to supply power to the PMOS. Similarly, the backside metal layers BM1N to BM3N serve as power supply metals; the ground terminal is connected to the metal M_{11N} at the first dielectric layer 431 through the through via V_{22N}, the through via V_{23N}, and the power supply through hole V_{21N}; and the metal M_{11N} at the first dielectric layer 431 is connected to the drain D_{N} of the NMOS through the contact hole V_{1N}, to supply power to the NMOS. A connection relationship between the source S_{P} of the PMOS and the power supply and a connection relationship between the drain D_{N} of the NMOS and the ground terminal change, and a connection relationship between another electrode of the PMOS and the NMOS and another signal remains unchanged. For example, a connection relationship between the drain D_{P} of the PMOS and the signal output end, a connection relationship between the gate G_{P} of the PMOS and the signal input end, a connection relationship between the source S_{N} of the NMOS and the signal output end, and a connection relationship between the gate G_{N} of the NMOS and the signal input end remain the same as those of an existing inverter.

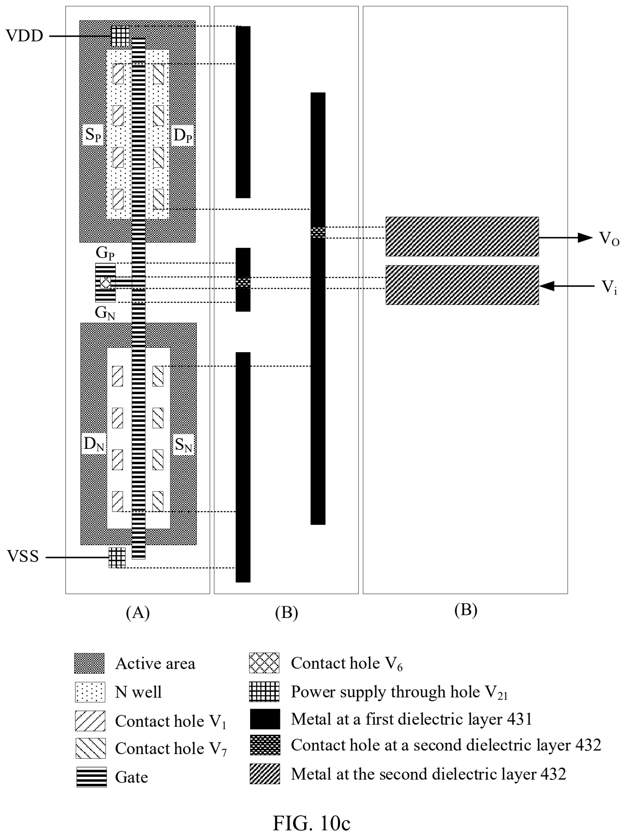

Further, FIG. 10c is a diagram of an example planar layout of an inverter according to this application. The diagram of the planar layout may be considered as a diagram seen after layers of the inverter are expanded in a top view direction. For example, (A) in FIG. 10c may be considered as a top view of an active layer on a wafer, (B) in FIG. 10c may be considered as a top view of a first dielectric layer, and (C) in FIG. 10c may be considered as a top view of a second dielectric layer. Optionally, the inverter may be prepared in an active area of the wafer. For example, in the figure, the inverter is prepared in a P-type active area. In this scenario, an active area corresponding to a PMOS in the inverter needs to be doped with an N-type material to form an N well, and an active area corresponding to an NMOS in the inverter may be doped with no another material. However, this is only a possible implementation. In some other scenarios, the inverter may alternatively be prepared in an N-type active area. This is not specifically limited in this application.

As shown in (A) in FIG. 10c to (C) in FIG. 10c, a power supply signal VDD provided by a power supply terminal may be transferred upward to a metal at a first dielectric layer 431 along a power supply through hole V₂₁, and may be transferred downward to a source S_{P} of the PMOS disposed on the wafer 410 through a contact hole V₁ in contact with the metal, thereby implementing a high level of the source S_{P} of the PMOS; and a ground signal VSS provided by the ground terminal may be transferred upward to the metal at the first dielectric layer 431 along the power supply through hole V₂₁, and may be transferred downward to a drain D_{N} of the NMOS disposed on the wafer 410 through the contact hole V₁ in contact with the metal, to implement a low level of the drain D_{N} of the NMOS. In addition, a drain D_{P} of the PMOS and a source S_{N} of the NMOS may be connected upward to the metal at the first dielectric layer 431 through a contact hole V₇, and may continue to be transferred upward through a contact hole that is at a second dielectric layer 432 and that is in contact with the metal, until being connected to am external signal output end of the inverter. A gate G_{P} of the PMOS and a gate G_{N} of the NMOS may be connected upward to the metal at the first dielectric layer 431 through a contact hole V₆, and may continue to be transferred upward through the contact hole that is at the second dielectric layer 432 and that is in contact with the metal, until being connected to an external signal input end of the inverter. In the foregoing layout manner, a metal trace used to transmit the power signal VDD and the ground signal VSS does not exist on a surface of the first dielectric layer 431 and a surface of the second dielectric layer 432. In this way, metal trace resources in a metal layer structure can be effectively saved.

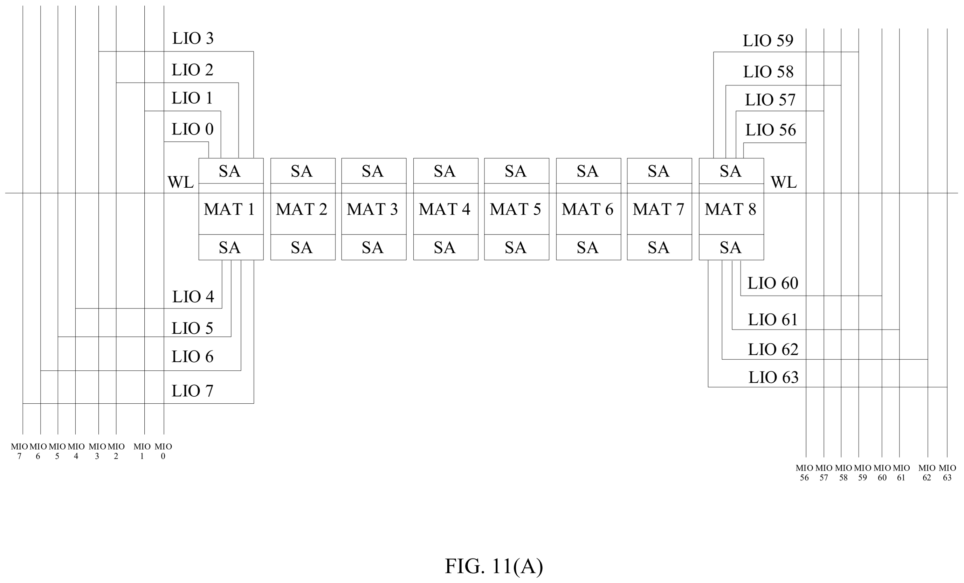

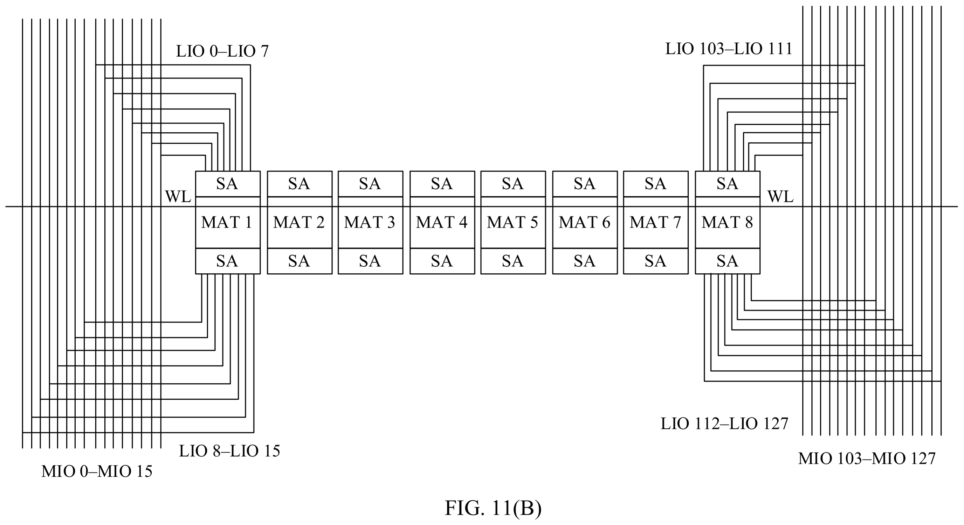

Further, if these saved metal wiring resources are used to expand more signal traces, for example, increase I/O traces, a memory bandwidth may be increased. For example, FIG. 11 is a diagram of an example circuit comparison of extending a saved power supply trace to an I/O trace according to this application. In the figure, data reading of one page (one page, including a plurality of MATs) in one bank in an x8 DRAM is used as an example. (A) in FIG. 11 is a diagram of a structure of the one page in the conventional x8 DRAM. (B) in FIG. 11 is a diagram of a structure of one page after I/O traces of the conventional x8 DRAM are multiplied. As shown in (A) in FIG. 11 and (B) in FIG. 11:

As shown in (A) in FIG. 11, in the conventional x8 DRAM, there are a total of eight MATs: an MAT 1 to an MAT 8. Each MAT corresponds to eight LIO traces and eight MIO traces, and other traces all serve as power supply traces. Therefore, after one WL is enabled, each MAT may output 8 bits (bit) of data, and one page may output 8×8 bits of data. For example, the MAT 1 is used as an example. If one WL intersects with 64 BLs, after one WL is enabled, 64 memory cells at an intersection between the WL and the 64 BLs are enabled, data in the 64 memory cells is transmitted to a surrounding SA circuit along the BLs on which the 64 memory cells are located, and the SA circuit selects eight pieces of data from 64 pieces of data and sends the eight pieces of data to the eight LIOs (namely, an LIO 0 to an LIO 7), and the eight LIOs amplify the eight pieces of transmitted data and transmit the eight pieces of data to the eight MIOs (an MIO 0 to an MIO 7). It can be learned that, in the conventional x8 DRAM, eight memory cells correspond to one LIO, and each LIO may select only one of the eight memory cells for data output. Therefore, a transmission bandwidth can be only 1/8 of a memory bandwidth.

As shown in (B) in FIG. 11, in an x8 DRAM obtained after I/O traces are multiplied, each MAT corresponds to 16 LIO traces and 16 MIO traces. Therefore, after one WL is enabled, each MAT may output 16 bits (bit) of data, and one page may output 16×8 bits of data. For example, the MAT 1 is still used as an example. If one WL intersects with 64 BLs, after one WL is enabled, 64 memory cells at an intersection between the WL and the 64 BLs are enabled, data in the 64 memory cells is transmitted to a surrounding SA circuit along the BLs on which the 64 memory cells are located, and the SA circuit selects 16 pieces of data from 64 pieces of data and sends the 16 pieces of data to the 16 LIOs, and the 16 LIOs amplify the 16 pieces of transmitted data and transmit the 16 pieces of data to the 16 MIOs. It can be learned that, in the x8 DRAM obtained after I/O traces are multiplied, four memory cells correspond to one LIO, and each LIO may select only one of the four memory cells for data output. Therefore, a memory bandwidth of the x8 DRAM obtained after I/O traces are multiplied can be multiplied to 1/4 as the I/O traces are multiplied.

It should be understood that the foregoing describes, by using an example in which the I/O traces are multiplied, only an effect that the memory bandwidth increases as the I/O traces increase. As described above, according to the backside wiring solution in this application, the I/O traces may be increased by a maximum of 2.77 times. Therefore, I/O traces of a memory chip may be increased by any factor not greater than 2.77 times, so that the memory bandwidth is correspondingly increased by corresponding times. This is not specifically limited in this application.

In addition, in this application, a preparation occasion of a second contact hole may be set by a person skilled in the art based on experience. For example, (A) in FIG. 4 is used as an example. In a preparation manner, a wafer 410, an active layer 420, an active device 421, a dielectric layer structure 430, a first metal M₁₁, and a first contact hole V₁ may be prepared; an entire structure is turned over; and the second contact hole V₂ is prepared starting from a backside of the wafer 410. Alternatively, in another preparation manner, a second contact hole V₂ may be prepared on one side of a wafer 410; the wafer 410 is turned over; and an active layer 420, an active device 421, a dielectric layer structure 430, a first metal M₁₁, and a first contact hole V₁ are prepared on the other side. There are many possible preparation manners. This is not specifically limited in this application.

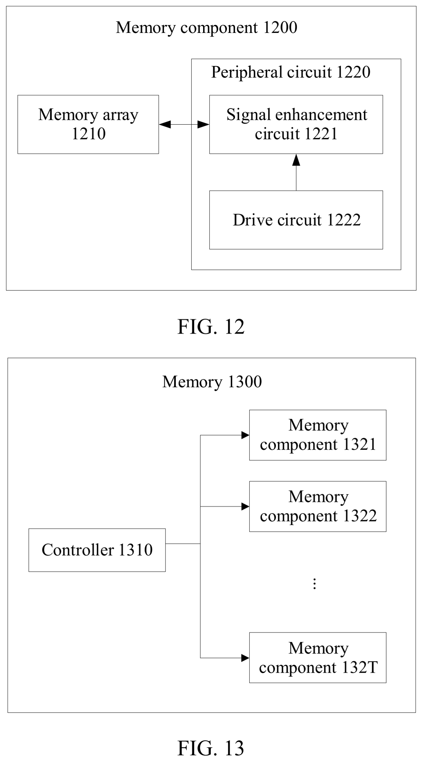

Based on the foregoing described structure and function principle of the memory chip, this application may further provide a memory component. The memory component may be, for example, a MAT in a memory. FIG. 12 is a diagram of a possible functional framework of a memory component according to this application. The memory component 1200 may include a memory array 1210 and a peripheral circuit 1220. The peripheral circuit 1220 may include the memory chip described in any one of the foregoing embodiments. One end of the peripheral circuit 1220 is connected to the memory array 1210, and the other end is connected to a controller (not shown in the figure), to transmit a control signal for reading/writing the memory array 1210 between the memory array 1210 and the controller.

In a possible implementation, still as shown in FIG. 12, the peripheral circuit 1220 may include a signal enhancement circuit 1221 and a drive circuit 1222. The signal enhancement circuit 1221 may be connected to the memory array 1210, and is configured to perform signal enhancement on the control signal of the read/write memory array 1210. The drive circuit 1222 may be connected to the signal enhancement circuit 1221, and is configured to perform power supply enhancement on the signal enhancement circuit 1221. The memory chip described in any one of the foregoing embodiments may be specifically located in the drive circuit 1222. For example, the drive circuit 1222 may include the inverter shown in FIG. 10b. The inverter is supplied with power by using a power supply signal or a ground signal introduced from a backside of a wafer, to implement a driving function of the signal enhancement circuit 1221 in combination with another drive device in the drive circuit 1222, so that the signal enhancement circuit 1221 can obtain enough electric energy to perform signal enhancement on the control signal for reading/writing the memory array 1210.

In a further possible implementation, as shown in FIG. 5 and FIG. 12 together, the signal enhancement circuit 1221 may include an SWD circuit and an SA circuit, the SWD circuit and the SA circuit may be located in a peripheral area of the memory array 1210, and the drive circuit 1222 may be located in an intersection area of the SWD circuit and the SA circuit, for example, a hole area shown in FIG. 5.

In a possible implementation, as shown in FIG. 5 and FIG. 12, the memory array may include M×N memory cells, M WLs, and N BLs, the M×N memory cells are located at an intersection of M WLs and N BLs, the SWD circuit is connected to the M WLs, and is configured to perform signal enhancement on a control signal transmitted on an enabled word line, and the SA circuit is connected to the N BLs, and is configured to perform signal enhancement on a control signal transmitted on an enabled bit line. M and N are positive integers.

It may be understood that the diagram of the circuit shown in FIG. 12 does not constitute a specific limitation on the memory component. In some other embodiments of this application, the memory component may include more or fewer parts than those shown in the figure, or combine some parts, or split some parts, or have different part arrangements, or have different position arrangements. This is not specifically limited.

Based on the foregoing described structure and function principle of the memory component, this application may further provide a memory. For example, FIG. 13 is a diagram of a possible functional framework of a memory according to this application. The memory 1300 may include a controller 1310 and T memory components described in any one of the foregoing embodiments, for example, a memory component 1321, a memory component 1322, ..., and a memory component 132T. T is a positive integer. The controller 1310 may be connected to any memory component, and is configured to perform a read/write operation on the any memory component.

In a possible implementation, as shown in FIG. 13 and FIG. 5 together, the controller 1310 may include a row decoder and a column decoder. The row decoder is connected to a WL in each memory component, and the column decoder is connected to a BL in each memory component. When a memory cell in a memory component needs to be read or written, the controller 1310 may send an enable control signal to a WL and a BL on which the memory cell in the memory component is located. In this way, an SWD circuit in the memory component performs signal enhancement on a control signal on an enabled WL and an SA circuit in the memory component performs signal enhancement on a control signal on an enabled BL, to drive a corresponding memory cell to be enabled, and implement a read/write operation on the memory cell.

It should be noted that the functional framework of the memory shown in FIG. 13 is merely an example. In another example, the memory 1300 may include more, fewer, or different devices. In addition, the shown devices may be combined or split in any manner. This is not specifically limited in this application.

For example, the memory may be a volatile memory or a nonvolatile memory, or may include both a volatile memory and a nonvolatile memory. The volatile memory may be a RAM and is used as an external cache. Through example but not limitation, many forms of RAM are available, for example, an SRAM, a DRAM, a flash memory (flash eprom, FE), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM), and for another example, a new type of memory such as a ferroelectric random access memory (ferroelectric random access memory, FeRAM), a phase change random access memory (phase change random access memory, PCRAM), a magnetic random access memory (magnetic random access memory, MRAM), or a resistive random access memory (resistive random access memory, ReRAM). The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. It should be noted that the memory described in this application aims to include but is not limited to these memories and any memory of another proper type.

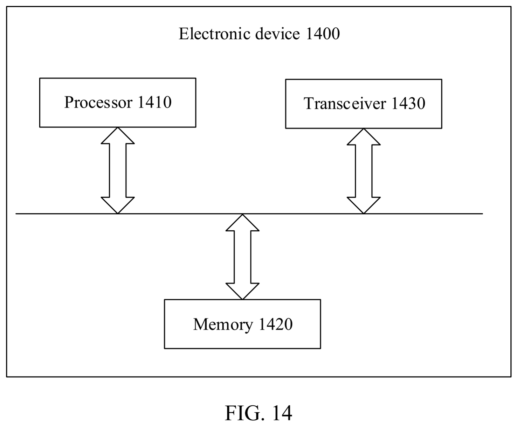

Based on the foregoing described structure and function principle of the memory, this application may further provide an electronic device. Optionally, the electronic device may be a memory device, for example, may include but is not limited to a removable hard disk, a USB flash drive, a memory card, or an optical disc. Alternatively, the electronic device may be a terminal device, for example, may be a mobile phone, a laptop, a smartwatch, a vehicle-mounted device, a computer, a virtual reality device, a projector, or a smart camera. FIG. 14 is a diagram of an example possible functional framework of an electronic device according to this application. The electronic device 1400 may include a processor 1410 and a memory 1420, or may further include a transceiver 1430. The memory 1420 may be the memory described in any one of the foregoing embodiments. The processor 1410 may be connected to peripheral elements of the processor 1410 such as the memory 1420 and the transceiver 1430 through a bus, for example, through an I/O bus. The processor 1410 may read/write data in the memory 1420 through the I/O bus.

The processor 1410 includes one or more processing units such as an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent devices, or may be integrated into one or more processors.

The memory 1420 may be specifically an internal memory, and may be configured to store computer-executable program code. The executable program code includes instructions. The internal memory may include a program storage area and a data storage area. The program storage area may store an operating system, an application required by at least one function (for example, a call function or a time setting function), and the like. The data storage area may store data (for example, an address book and a world clock) and the like created when the electronic device is used. In addition, the internal memory may include a high-speed random access memory, or may include a nonvolatile memory, for example, at least one magnetic disk memory device, a flash memory, or a universal flash storage (Universal Flash Storage, UFS). The processor 1410 runs the instructions stored in the internal memory, to perform various function applications of the electronic device 1400 and data processing.

In some scenarios, the electronic device 1400 may further include an interface for external memory. The electronic device 1400 may be connected to an external storage card, for example, a Micro SD card, through the interface for external memory, to extend a storage capability of the electronic device 1400. For example, the external memory card communicates with the processor 1410 through the interface for external memory, to implement a data storage function.

The transceiver 1430 may enable the electronic device 1400 to perform wireless communication externally, and may provide a wireless communication solution such as a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, or an infrared (infrared, IR) technology. The transceiver 1430 may be one or more devices integrating at least one communication processor module. The transceiver 1430 receives an electromagnetic wave through the antenna, performs frequency modulation and filtering processing on an electromagnetic wave signal, and sends a processed signal to the processor 1410. The transceiver 1430 may further receive a to-be-sent signal from the processor 1410, perform frequency modulation and amplification on the signal, and convert the signal into an electromagnetic wave for radiation through the antenna.

It should be noted that the functional framework of the electronic device shown in FIG. 14 is merely an example. In some other embodiments of this application, the electronic device may include more or fewer components than those shown in the figure, or combine some components, or split some components, or have different component arrangements. The components shown in the figure may be implemented by hardware, software, or a combination of software and hardware.

In various embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

In this application, the "contact hole" is not an absolutely regular hole, and may be understood as a hole of any shape that can connect upper and lower parts, for example, may be an irregularly-shaped hole. "At least one" means one or more, and "a plurality of" means two or more. "And/or" describes an association between associated objects, and indicates that three relationships may exist. For example, A and/or B may indicate the following three cases: Only A exists, both A and B exist, and only B exists, where A and B may be singular or plural. "At least one of the following items (pieces)" or a similar expression thereof refers to any combination of these items, including a single item (piece) or any combination of a plurality of items (pieces). For example, at least one of a, b, or c may indicate a, b, c, a and b, a and c, b and c, or a, b, and c, where a, b, and c may be singular or plural. In text descriptions of this application, the character "/" generally represents an "or" relationship between associated objects. In a formula of this application, the character "/" indicates a "division" relationship between associated objects. In addition, the term "for example" in this application is used to represent giving an example, an illustration, or a description. Any embodiment or design scheme described as an "example" in this application should not be explained as being more preferred or having more advantages than another embodiment or design scheme. Alternatively, it may be understood as that the word "example" is used to present a concept in a specific manner, and does not constitute a limitation on this application.

It may be understood that various numbers in this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes. The terms "first", "second", and the like are used to distinguish between similar objects without having to describe a specific order or sequence. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

## Claims

1. A memory chip, comprising:
a wafer and an active layer embedded in the wafer, wherein
the active layer comprises an active device, the active device is a device in a peripheral circuit of the memory chip, and a first electrode of the active device is supplied with power by being in contact with a power supply or a ground on a backside of the wafer; and
signal wiring is performed for a memory array in the memory chip by using a metal resource on a side that is of the wafer and on which an active surface is located.

2. The memory chip according to claim 1, wherein the peripheral circuit comprises a drive circuit, and the active device is a device in the drive circuit.

3. The memory chip according to claim 1 or 2, wherein
the memory chip further comprises a dielectric layer structure disposed on the active surface of the wafer and a first metal disposed in the dielectric layer structure; and
the first electrode of the active device is in contact with the first metal through a first contact hole, and the first metal further penetrates through a second contact hole to the backside of the wafer, and is conducted to the power supply or the ground.

4. The memory chip according to claim 3, wherein a contact area between the second contact hole and the first metal is at least partially projected in a first area, and the first area is an area for storing the drive circuit in the memory chip.

5. The memory chip according to claim 1 or 2, wherein
the wafer comprises a third contact hole, one end of the third contact hole is in contact with the first electrode, and the other end of the third contact hole penetrates to the backside of the wafer and is conducted to the power supply or the ground.

6. The memory chip according to any one of claims 3 to 5, wherein for either the second contact hole or the third contact hole:
a power supply through hole and a first backside metal layer are comprised, one end of the power supply through hole is in contact with the first metal or the first electrode, the other end of the power supply through hole penetrates to the first backside metal layer, and the first backside metal layer is conducted to the power supply or the ground.

7. The memory chip according to claim 6, wherein the first backside metal layer is spread over the backside of the wafer, the power supply through hole is at least partially projected in the first area, and the first area is an area for storing the drive circuit in the memory chip.

8. A memory component, comprising a memory array and a peripheral circuit, wherein the peripheral circuit comprises the memory chip according to any one of claims 1 to 7; and
the peripheral circuit is configured to transmit, between the memory array and a controller, a control signal for reading/writing the memory array.

9. The memory component according to claim 8, wherein the peripheral circuit comprises a signal enhancement circuit and a drive circuit;
the drive circuit is configured to perform power supply enhancement on the signal enhancement circuit; and
the signal enhancement circuit is configured to perform signal enhancement on the control signal for reading/writing the memory array.

10. The memory component according to claim 9, wherein the signal enhancement circuit comprises a sub word line driver SWD circuit and a sense amplifier SA circuit, the SWD circuit and the SA circuit are located in a peripheral area of the memory array, and the drive circuit is located in an intersection area of the SWD circuit and the SA circuit.

11. The memory component according to claim 10, wherein the memory array comprises M×N memory cells, M word lines, and N bit lines, the M×N memory cells are located at an intersection of the M word lines and the N bit lines, the SWD circuit is connected to the M word lines, the SA circuit is connected to the N bit lines, and M and N are positive integers;
the SWD circuit is configured to perform signal enhancement on a control signal transmitted on an enabled word line; and
the SA circuit is configured to perform signal enhancement on a control signal transmitted on an enabled bit line.

12. A memory, comprising a controller and the memory component according to any one of claims 8 to 11, wherein the controller is connected to the memory component; and
the controller is configured to perform a read/write operation on the memory component.

13. An electronic device, comprising a processor and the memory according to claim 12, wherein the processor and the memory are connected through an input/output I/O bus; and
the processor is configured to read/write data in the memory through the I/O bus.
